# EUROPEAN PATENT APPLICATION

(11) **EP 4 664 197 A1**
(43) Date of publication of application: **17.12.2025**
(21) Application number: 23921377.0
(22) Date of filing: 22.12.2023
(51) Int. Cl.: G03F 7/075, C08G 77/52, G03F 7/004

(54) **PHOTOSENSITIVE RESIN COMPOSITION, PHOTOSENSITIVE RESIN COATING FILM, PHOTOSENSITIVE DRY FILM, AND PATTERN FORMATION METHOD**

(30) Priority: 06.02.2023 JP 2023016294
(71) Applicant: SHIN-ETSU CHEMICAL CO., LTD., Tokyo 1000005 (JP)
(72) Inventor: MARUYAMA, Hitoshi, Annaka-shi Gunma 379-0224 (JP)
(74) Representative: Ter Meer Steinmeister & Partner
(86) International application number: PCT/JP2023/046171
(87) International publication number: WO 2024/166559

(57) **Abstract**

Provided is a photosensitive resin composition comprising (A) a silicone resin having an acid-crosslinkable group, (B) an epoxy compound represented by formula (B1), and (C) a photoacid generator. 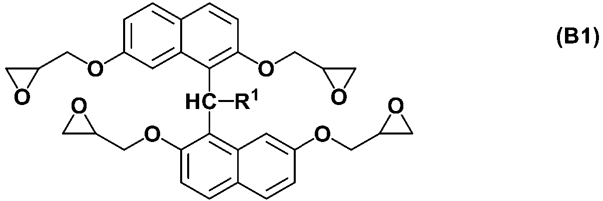 (In formula (B1), R¹ is a hydrogen atom, a C1-4 saturated hydrocarbyl group, a phenyl group, a hydroxyphenyl group, or a halogen-substituted phenyl group.)

## Description

### TECHNICAL FIELD

The present invention relates to a photosensitive resin composition, a photosensitive resin coating film, a photosensitive dry film and a patterning method.

### BACKGROUND ART

Photosensitive polyimide compositions, photosensitive epoxy resin compositions, photosensitive silicone compositions and the like have hitherto been used as semiconductor device-protecting films and multilayer printed circuit board insulating films that have photosensitivity. Photosensitive silicone compositions of outstanding flexibility in particular have been described as photosensitive materials suitable for protecting such substrates and circuits (Patent Document 1). These photosensitive silicone compositions are curable at low temperatures and can form coating films of excellent reliability, including moisture-resistant adhesion, but they have a poor chemical resistance to photoresist strippers having a strong dissolving power, such as N-methyl-2-pyrrolidone.

To address this, photosensitive silicone compositions composed primarily of a silphenylene skeleton-containing silicone polymer have been disclosed (Patent Document 2). Although such photosensitive silicone compositions exhibit an improved resistance to photoresist strippers and the like, they have a number of drawbacks. For example, the cured product peels from the substrate following heat resistance testing and the bond strength with the substrate is low. The solder resistance also poses a problem. Hence, there exists a desire for further improvement.

### PRIOR ART DOCUMENTS

### PATENT DOCUMENTS

Patent Document 1: JP-A 2002-88158
Patent Document 2: JP-A 2008-184571

### SUMMARY OF INVENTION

### TECHNICAL PROBLEM

The present invention was arrived at in light of the above circumstances. The objects of the invention are a photosensitive resin composition, a photosensitive resin coating film, a photosensitive dry film and a patterning method using these which enable the formation of a vertical pattern of small geometry to be easily carried out in a thick film and moreover enable the formation of a resin coating film (resin layer) that has various excellent film properties, including solder resistance, heat resistance, crack resistance, adhesion to the base materials used in substrates, electronic components, semiconductor devices and the like, especially circuit boards, and has an excellent reliability as a coating film for protecting electrical and electronic components and as a coating film for substrate bonding.

### SOLUTION TO PROBLEM

The inventor has conducted intensive investigations aimed at achieving the above objects, discovering as a result that these objects can be achieved with a photosensitive resin composition which includes (A) an acid crosslinkable group-containing silicone resin, (B) an epoxy compound having a specific structure, and (C) a photoacid generator. This discovery ultimately led to the present invention.

Accordingly, the invention provides the following photosensitive resin composition, photosensitive resin coating film, photosensitive dry film and patterning method.
1. A photosensitive resin composition which includes:
   (A) an acid-crosslinkable group-containing silicone resin,
   (B) an epoxy compound of formula (B1) below 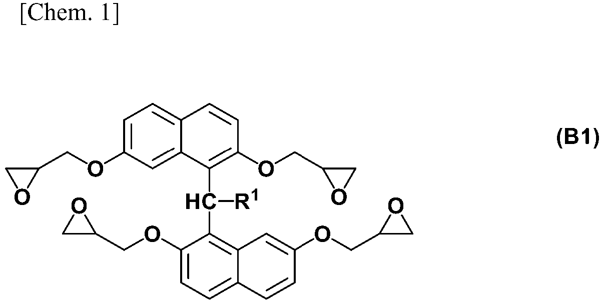 (wherein R¹ is a hydrogen atom, a saturated hydrocarbyl group of 1 to 4 carbon atoms, a phenyl group, a hydroxyphenyl group or a halogen-substituted phenyl group), and
   (C) a photoacid generator.
2. The photosensitive resin composition of 1 above, wherein the silicone resin (A) is a compound of formula (A1) below 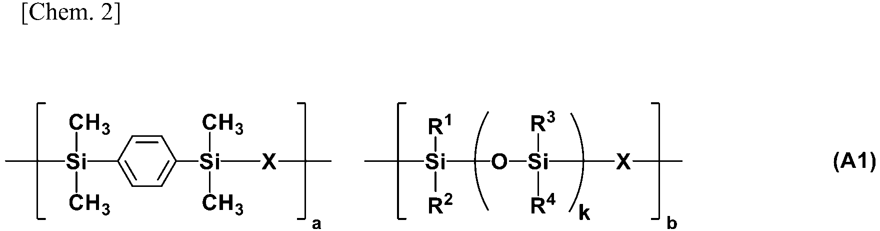 (wherein R¹ to R⁴ are each independently a hydrocarbyl group of 1 to 8 carbon atoms; k is an integer from 1 to 600; a and b are numbers which represent the compositional ratios (molar ratios) of the respective recurring units and satisfy the conditions 0 < a < 1, 0 < b < 1 and a+b = 1; and X is a divalent organic group that includes an epoxy group and/or a phenolic hydroxyl group).
3. The photosensitive resin composition of 2 above, wherein the silicone resin (A) includes recurring units of formulas (a1) to (a4) and (b1) to (b4) below 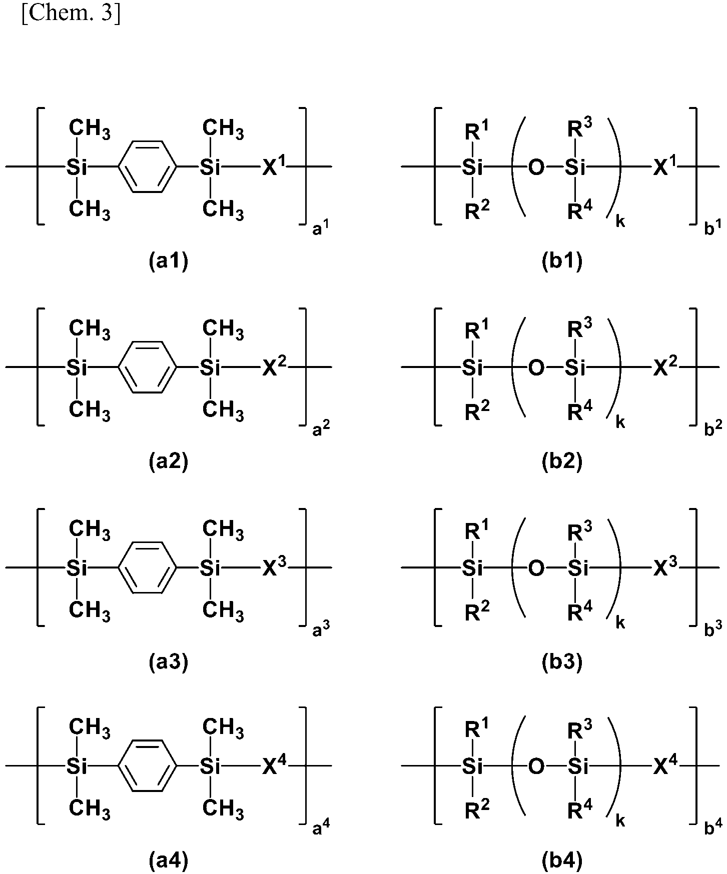
   [wherein R¹ to R⁴ are each independently a hydrocarbyl group of 1 to 8 carbon atoms; k is an integer from 1 to 600; a¹ to a⁴ and b¹ to b⁴ are numbers which represent the compositional ratios (molar ratios) of the respective recurring units and satisfy the conditions 0 ≤ a¹ < 1, 0 ≤ a² < 1, 0 ≤ a³ < 1, 0 ≤ a⁴ < 1, 0 ≤ b¹ < 1, 0 ≤ b² < 1, 0 ≤ b³ < 1, 0 ≤ b⁴ < 1, 0 < a¹+a²+a³ < 1, 0 < b¹+b²+b³ < 1 and a¹+a²+a³+a⁴+b¹+b²+b³+b⁴ = 1; X¹ is a divalent group of formula (X1) below 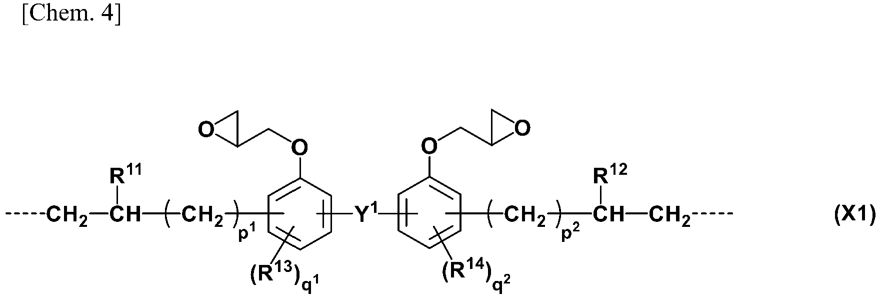
   (wherein Y¹ is a single bond, a methylene group, a propane-2,2-diyl group, a 1, 1, 1,3,3,3-hexafluoropropane-2,2-diyl group or a fluorene-9,9-diyl group, R¹¹ and R¹² are each independently a hydrogen atom or a methyl group, R¹³ and R¹⁴ are each independently a saturated hydrocarbyl group of 1 to 4 carbon atoms or a saturated hydrocarbyloxy group of 1 to 4 carbon atoms, p¹ and p² are each independently an integer from 0 to 7, q¹ and q² are each independently an integer from 0 to 2, and the dashed lines represent bonds); X² is a divalent group of formula (X2) below 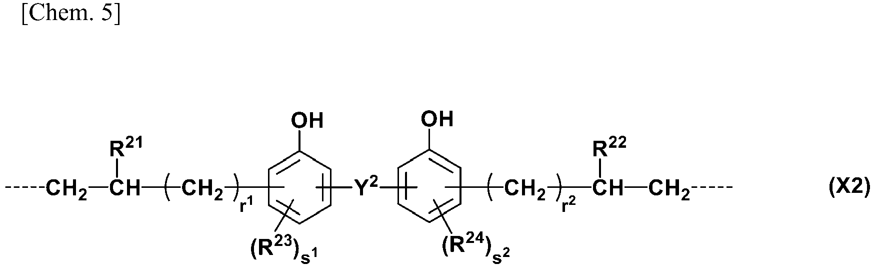
   (wherein Y² is a single bond, a methylene group, a propane-2,2-diyl group, a 1,1,1,3,3,3-hexafluoropropane-2,2-diyl group or a fluorene-9,9-diyl group, R²¹ and R²² are each independently a hydrogen atom or a methyl group, R²³ and R²⁴ are each independently a saturated hydrocarbyl group of 1 to 4 carbon atoms or a saturated hydrocarbyloxy group of 1 to 4 carbon atoms, r¹ and r² are each independently an integer from 0 to 7, s¹ and s² are each independently an integer from 0 to 2, and the dashed lines represents bonds); X³ is a divalent group of formula (X3) below 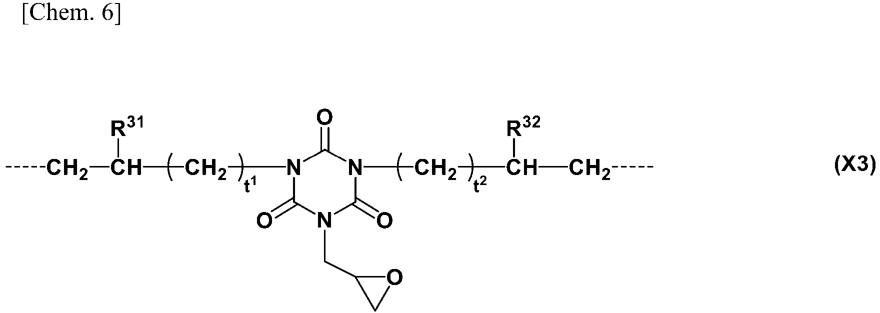
   (wherein R³¹ and R³² are each independently a hydrogen atom or a methyl group, t¹ and t² are each independently an integer from 0 to 7, and the dashed lines represents bonds); and X⁴ is a divalent group of formula (X4) below 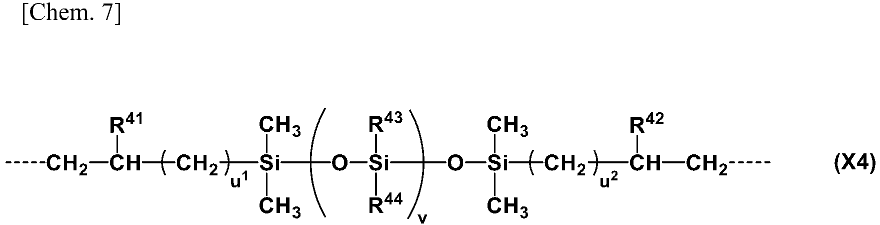
   (wherein R⁴¹ and R⁴² are each independently a hydrogen atom or a methyl group, R⁴³ and R⁴⁴ are each independently a hydrocarbyl group of 1 to 8 carbon atoms, u¹ and u² are each independently an integer from 0 to 7, v is an integer from 0 to 600, and the dashed lines represent bonds)].
4. The photosensitive resin composition of any of 1 to 3 above, wherein the epoxy compound of component (B) is included in an amount of from 3 to 100 parts by weight per 100 parts by weight of component (A).
5. The photosensitive resin composition of any of 1 to 4 above, further including (D) a crosslinking agent.
6. The photosensitive resin composition of 5 above, wherein the crosslinking agent (D) is at least one compound selected from the group consisting of: nitrogen-containing compounds selected from melamine compounds, guanamine compounds, glycoluril compounds and urea compounds containing an average of two or more methylol groups and/or alkoxymethyl groups per molecule, amino condensation products modified by formaldehyde or formaldehyde-alcohol, phenol compounds having an average of two or more methylol or alkoxymethyl groups per molecule, and epoxy compounds having an average of two or more epoxy groups per molecule.
7. The photosensitive resin composition of any of 1 to 6 above, further including (E) a solvent.
8. A photosensitive resin coating film obtained from the photosensitive resin composition of any of 1 to 7 above.
9. A photosensitive dry film having a support film and, on the support film, the photosensitive resin coating film of 8 above.
10. A patterning method which includes the steps of:
   (i) forming a photosensitive resin coating film on a substrate by using the photosensitive resin composition of any of 1 to 7 above,
   (ii) exposing the photosensitive resin coating film to light, and
   (iii) patterning the exposed photosensitive resin coating film by development with a developer.
11. A patterning method which includes the steps of:
   (i') forming a photosensitive resin coating film on a substrate by using the photosensitive dry film of 9 above,
   (ii) exposing the photosensitive resin coating film to light, and
   (iii) patterning the exposed photosensitive resin coating film by development with a developer.
12. The patterning method of 10 or 11 above which further includes the step of:
   (iv) post-curing, at a temperature between 100°C and 250°C, the photosensitive resin coating film that has been patterned by development.
13. The photosensitive resin composition of any of 1 to 7 above which is a material for a coating film for protecting electrical and electronic components.
14. The photosensitive resin composition of any of 1 to 7 above which is a material for a substrate-bonding coating film for bonding two substrates.

### ADVANTAGEOUS EFFECTS OF INVENTION

The photosensitive resin composition of the invention can form coating films having a broad range in thickness, and moreover readily enables the formation, in a thick film, of patterns of small geometry and excellent verticality by the subsequently described patterning method. Coating films obtained using the photosensitive resin composition and photosensitive dry film of the invention have excellent solder resistance, excellent heat resistance and low susceptibility to substrate warpage, have also excellent mechanical properties such as crack resistance and adhesion to the base materials used in substrates, electronic components, semiconductor devices and the like, especially circuit boards, and additionally have an excellent resistance to copper migration. In addition, such coating films have a high reliability as insulating protective films and can be suitably used as film-forming materials for protecting various types of electrical and electronic components such as circuit boards, semiconductor devices and display devices and as substrate bonding film-forming materials.

### DESCRIPTION OF EMBODIMENTS

### [Photosensitive Resin Composition]

The photosensitive resin composition of the invention includes (A) an acid-crosslinkable group-containing silicone resin, (B) an epoxy compound of a specific structure, and (C) a photoacid generator.

### [(A) Acid-Crosslinkable Group-Containing Silicone Resin]

The silicone resin of component (A) is a compound which contains acid-crosslinkable groups on the molecule. As used here, "acid-crosslinkable group" refers to a group capable of chemically bonding under the action of an acid, either directly between functional groups or through a crosslinking agent. The acid-crosslinkable groups are preferably epoxy groups and phenolic hydroxyl groups. Epoxy groups alone or phenolic hydroxyl groups alone may be included, or both may be included.

The acid-crosslinkable group-containing silicone resin is preferably one of formula (A) below.

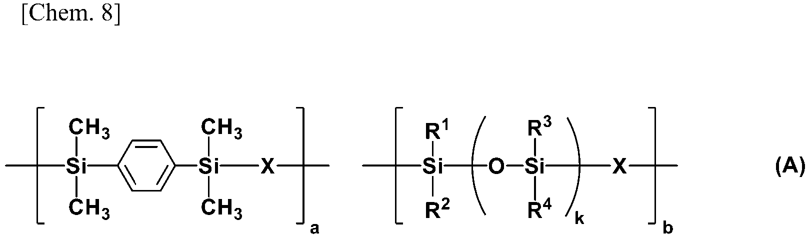

In formula (A), R¹ to R⁴ are each independently a hydrocarbyl group of 1 to 8 carbon atoms; one of 1 to 6 carbon atoms is preferred. The subscript 'k' is an integer from 1 to 600, preferably an integer from 1 to 400, and more preferably an integer from 1 to 200. The subscripts 'a' and 'b' are numbers which represent the compositional ratios (molar ratios) of the respective recurring units and satisfy the conditions 0 < a < 1, 0 < b < 1 and a+b = 1. X is an epoxy group and/or phenolic hydroxyl group-containing divalent organic group.

The hydrocarbyl group may be linear, branched or cyclic. Specific examples include alkyl groups such as methyl, ethyl, propyl and hexyl groups, and also structural isomers of these; cyclic saturated hydrocarbyl groups such as the cyclohexyl group; and aryl groups such as the phenyl group. Of these, methyl and phenyl groups are preferred on account of the ready availability of the starting materials.

It is especially preferable for the silicone resin of formula (A) to be one which includes recurring units of formulas (a1) to (a4) and (b1) to (b4) below (also referred to below as, respectively, recurring units a1 to a4 and b1 to b4) 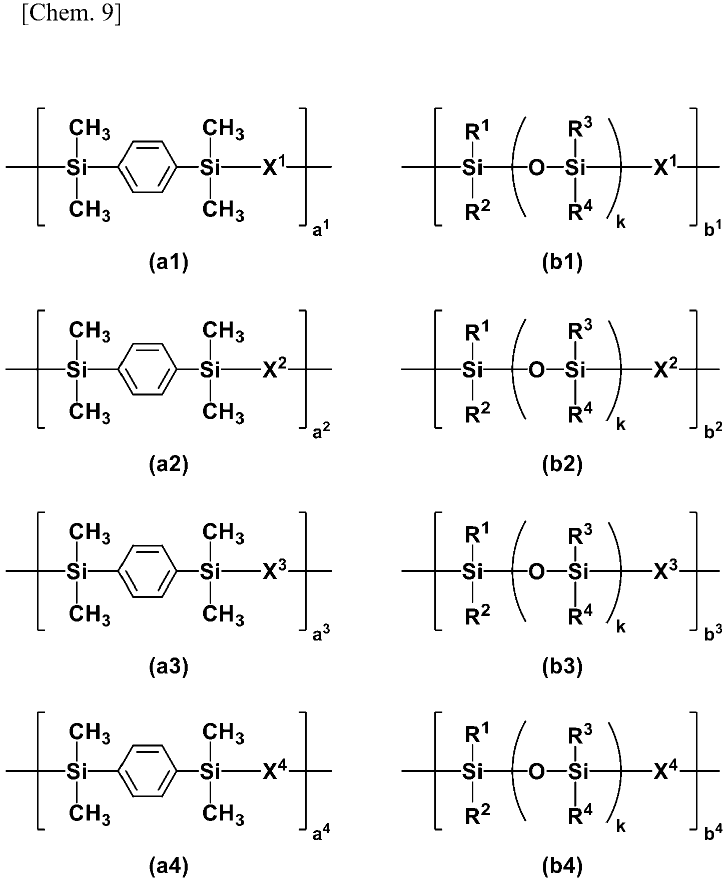 (wherein R¹ to R⁴ and k are as defined above).

In formulas (a1) and (b1), X¹ is a divalent group of formula (X1) below 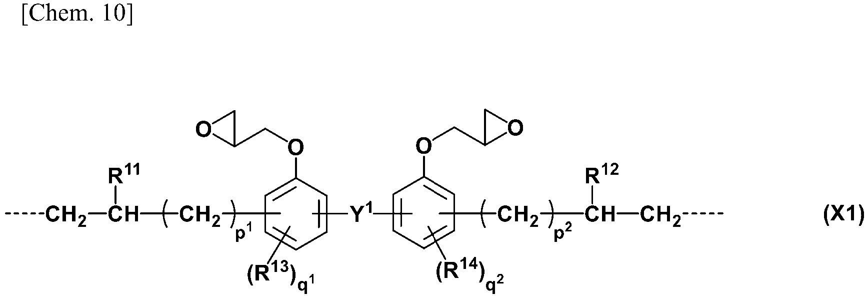 (wherein the dashed lines represent bonds).

In formula (X1), Y¹ is a single bond, a methylene group, a propane-2,2-diyl group, a 1,1,1,3,3,3-hexafluoropropane-2,2-diyl group or a fluorene-9,9-diyl group; R¹¹ and R¹² are each independently a hydrogen atom or a methyl group; R¹³ and R¹⁴ are each independently a saturated hydrocarbyl group of 1 to 4 carbon atoms or a saturated hydrocarbyloxy group of 1 to 4 carbon atoms; p¹ and p² are each independently an integer from 0 to 7; and q¹ and q² are each independently an integer from 0 to 2.

The saturated hydrocarbyl group may be linear, branched or cyclic. Specific examples include alkyl groups such as methyl, ethyl, propyl and butyl groups, as well as structural isomers of these; and cyclic saturated hydrocarbyl groups such as the cyclopropyl and cyclobutyl groups. The saturated hydrocarbyloxy group may be linear, branched or cyclic. Specific examples include alkoxy groups such as methoxy, ethoxy, propoxy and butoxy groups, as well as structural isomers of these; and cyclic saturated hydrocarbyloxy groups such as cyclopropyloxy and cyclobutyloxy groups.

In formulas (a2) and (b2), X² is a divalent group of formula (X2) below. 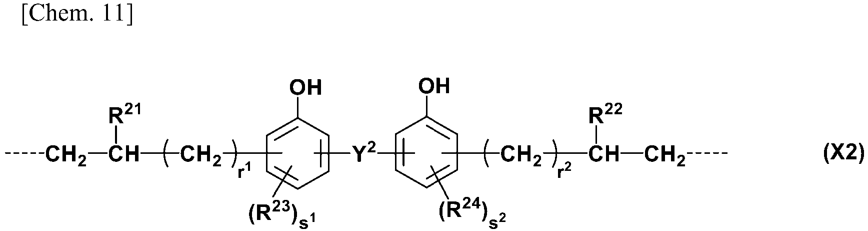 (wherein the dashed lines represent bonds).

In formula (X2), Y² is a single bond, a methylene group, a propane-2,2-diyl group, a 1,1,1,3,3,3-hexafluoropropane-2,2-diyl group or a fluorene-9,9-diyl group; R²¹ and R²² are each independently a hydrogen atom or a methyl group; R²³ and R²⁴ are each independently a saturated hydrocarbyl group of 1 to 4 carbon atoms or a saturated hydrocarbyloxy group of 1 to 4 carbon atoms; r¹ and r² are each independently an integer from 0 to 7; and s¹ and s² are each independently an integer of 0 to 2. The saturated hydrocarbyl group and saturated hydrocarbyloxy group are exemplified by the same groups as mentioned above in connection with R¹³ and R¹⁴.

In formulas (a3) and (b3), X³ is a divalent group of formula (X3) below 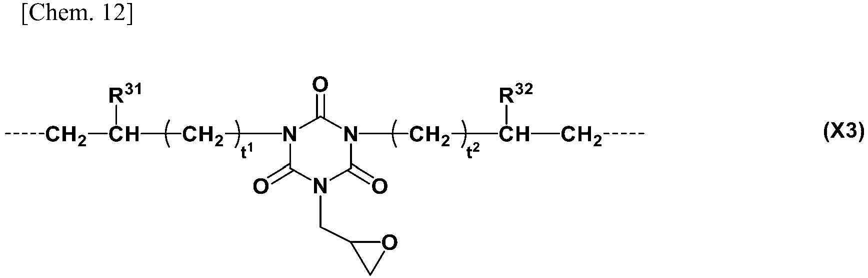 (wherein the dashed lines are bonds).

In formula (X3), R³¹ and R³² are each independently a hydrogen atom or a methyl group; and t¹ and t² are each independently an integer from 0 to 7.

In formulas (a4) and (b4), X⁴ is a divalent group of formula (X4) below 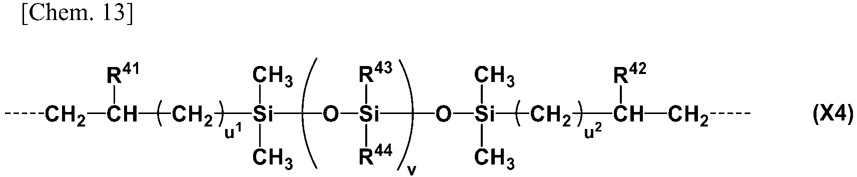 (wherein the dashed lines are bonds).

In formula (X4), R⁴¹ and R⁴² are each independently a hydrogen atom or a methyl group; R⁴³ and R⁴⁴ are each independently a hydrocarbyl group of 1 to 8 carbon atoms; u¹ and u² are each independently an integer from 0 to 7; and v is an integer from 0 to 600, preferably an integer from 0 to 400, and more preferably an integer from 0 to 200. The hydrocarbyloxy group is exemplified by the same groups as mentioned above in connection with R¹ to R⁴.

The silicone resin of component (A) is one having a weight-average molecular weight (Mw) of preferably from 3,000 to 500,000, and more preferably from 5,000 to 200,000. In this invention, the Mw is a polystyrene-equivalent measured value obtained by gel permeation chromatography (GPC) using tetrahydrofuran (THF) as the eluting solvent.

In formulas (a1) to (a4) and (b1) to (b4), a¹ to a⁴ and b¹ to b⁴ are numbers which represent the compositional ratios (molar ratios) of the respective recurring units and which satisfy the conditions 0 ≤ a¹ < 1, 0 ≤ a² < 1, 0 ≤ a³ < 1, 0 ≤ a⁴ < 1, 0 ≤ b¹ < 1, 0 ≤ b² < 1, 0 ≤ b³ < 1, 0 ≤ b⁴ < 1, 0 < a¹+a²+a³ < 1,0 < b¹+b²+b³ < 1 and a¹+a²+a³+a⁴+b¹+b²+b³+b⁴ = 1; more preferably numbers which satisfy the conditions 0 ≤ a¹ ≤ 0.8, 0 ≤ a² ≤ 0.8, 0 ≤ a³ ≤ 0.8, 0 ≤ a⁴ ≤ 0.8, 0 ≤ b¹ ≤ 0.95, 0 ≤ b² ≤ 0.95, 0 ≤ b³ ≤ 0.95, 0 ≤ b⁴ ≤ 0.95, 0.05 ≤ a¹+a²+a³ ≤ 0.8, 0.2 ≤ b¹+b²+b³ ≤ 0.95 and a¹+a²+a³+a⁴+b¹+b²+b³+b⁴ = 1; and even more preferably numbers which satisfy the conditions 0 ≤ a¹ ≤ 0.7, 0 ≤ a² ≤ 0.7, 0 ≤ a³ ≤ 0.7, 0 ≤ a⁴ ≤ 0.7, 0 ≤ b¹ ≤ 0.9, 0 ≤ b² ≤ 0.9, 0 ≤ b³ ≤ 0.9, 0 ≤ b⁴ ≤ 0.9, 0.1 ≤ a¹+a²+a³ ≤ 0.7, 0.3 ≤ b¹+b²+3³ ≤ 0.9 and a¹+a²+a³+a⁴+b¹+b²+b³+b⁴ = 1. Moreover, from the standpoint of the reaction, it is preferable for 0 < b² < 1, more preferable for 0.2 ≤ b² ≤ 0.95, and still more preferable for 0.3 ≤ b² ≤ 0.9.

The above respective recurring units may be randomly bonded, or may be bonded as a block polymer. Alternatively, in cases where there are two or more siloxane units within the respective recurring units, the siloxane units may all be the same or may include differing siloxane units of two or more types. **In** cases where differing siloxane units of two or more types are included, the siloxane units may be randomly bonded or a plurality of blocks of like siloxane units may be included. Also, in this silicone resin, the silicone (siloxane unit) content is preferably from 30 to 80 wt%.

The silicone resin of component (A) functions as a compound that imparts a film-forming ability. The resulting resin film has a good adhesion to laminates, substrates and the like, and a good pattern formability, cracking resistance and heat resistance.

The silicone resin of component (A) may be of one type used alone, or two or more may be used in combination.

### [(A) Method for Preparing Silicone Resin]

The silicone resin of component (A) can be prepared by addition polymerizing a compound of formula (1) below, a compound of formula (2) below, at least one compound selected from the group consisting of compounds of formula (3) below, compounds of formula (4) below and compounds of formula (5) below and, optionally, a compound of formula (6) below in the presence of a metal catalyst. 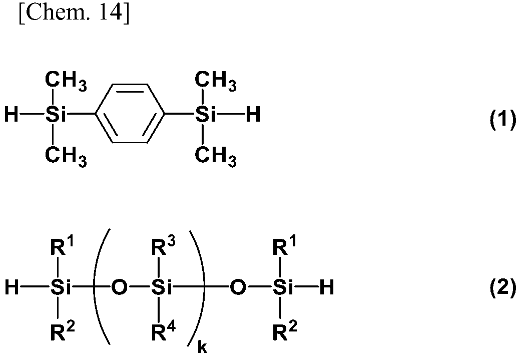 In thee formulas, R¹ to R⁴ and k are the same as above. 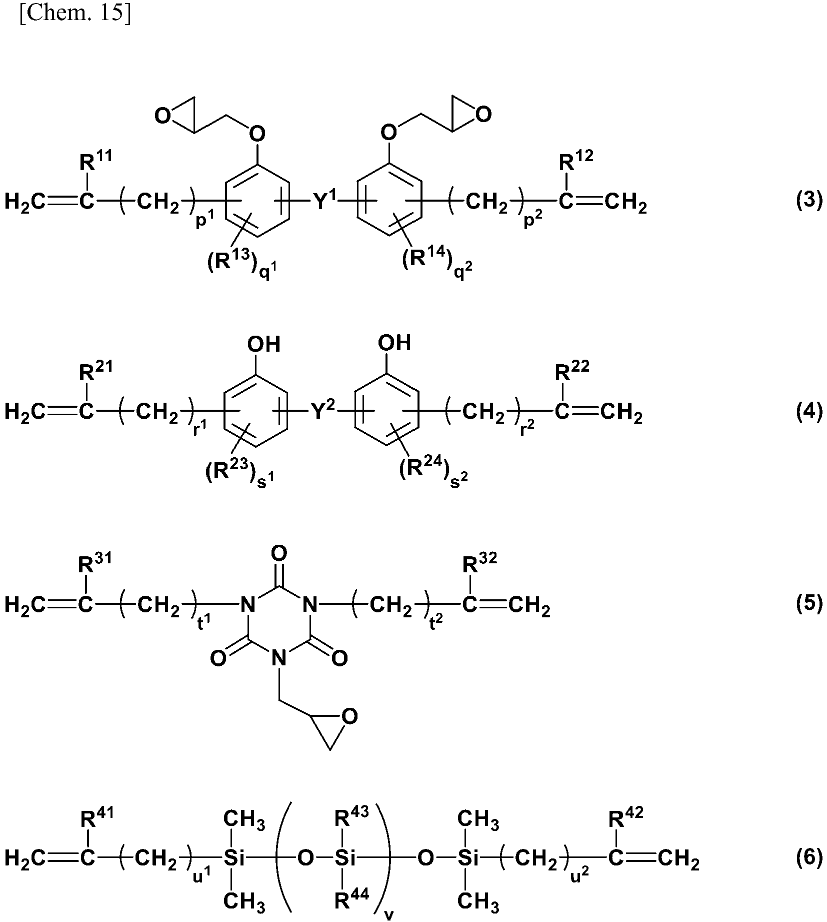 In these formulas, R¹¹ to R¹⁴, R²¹ to R²⁴, R³¹, R³², R⁴¹ to R⁴⁴, Y¹, Y², p¹, p², q¹, q², r¹, r², s¹, s², t¹, t², u¹, u² and v are the same as above.

Any of the following may be used as the metal catalyst: uncombined platinum group metals such as platinum (including platinum black), rhodium and palladium; platinum chloride, chloroplatinic acid and chloroplatinic acid salts, such as H₂PtCl₄·xH₂O, H₂PtCl₆·xH₂O, NaHPtCl₆·xH₂O, KHPtCl₆·xH₂O, Na₂PtCl₆·xH₂O, K₂PtCl₄·xH₂O, PtCl₄·xH₂O, PtCl₂ and Na₂HPtCl₄·xH₂O (wherein x is preferably an integer from 0 to 6, and is most preferably 0 or 6); alcohol-modified chloroplatinic acids (e.g., those mentioned in U.S. Pat. No. 3,220,972); complexes of chloroplatinic acid and olefins (e.g., those mentioned in U.S. Pat. Nos. 3,159,601, 3,159,662 and 3,775,452); platinum group metals such as platinum black or palladium on a support such as alumina, silica or carbon; rhodium-olefin complexes; chlorotris(triphenylphosphine)rhodium (so-called Wilkinson's catalyst); and complexes of platinum chloride, chloroplatinic acid or chloroplatinic acid salt with a vinyl group-containing siloxane (particularly a vinyl group-containing cyclic siloxane).

The catalyst is used in a catalytic amount. In general, this is preferably from 0.001 to 0.1 part by weight, and more preferably from 0.01 to 0.1 part by weight, per 100 parts by weight of the sum of the starting compounds.

If necessary, a solvent may be used in the addition polymerization reaction. The solvent is preferably a hydrocarbon-type solvent such as toluene or xylene.

To enable polymerization to go to completion in a short time without deactivation of the catalyst, the polymerization temperature is preferably between 40°C and 150°C, and more preferably between 60°C and 120°C. Although the polymerization time depends also on the type and amount of the resin to be obtained, to prevent the introduction of moisture into the polymerization system, the polymerization time is preferably from about 0.5 hour to about 100 hours, and more preferably from about 0.5 hour to above 30 hours. Following completion of the polymerization reaction, the silicone resin of component (A) can be obtained by, in cases where a solvent has been used, distilling off the solvent.

The reaction method is not particularly limited. For example, in cases where a compound of formula (1), a compound of formula (2), at least one compound selected from compounds of formula (3), compounds of formula (4) and compounds of formula (5) and, optionally, a compound of formula (6) are reacted, the method may involve first mixing together and heating at least one compound selected from compounds of formula (3), compounds of formula (4) and compounds of formula (5) and, optionally, a compound of formula (6), subsequently adding a metal catalyst to the mixture, and then adding dropwise the compound of formula (1) and the compound of formula (2) over a period of 0.1 to 5 hours.

The respective compounds may be formulated such that the sum of the hydrosilyl groups on the compound of formula (1) and the compound of formula (2) with respect to the sum of the alkenyl groups on the at least one compound selected from compounds of formula (3), compounds of formula (4) and compounds of formula (5) and on, optionally, the compound of formula (6), expressed as a molar ratio, is preferably from 0.67 to 1.67, and more preferably from 0.83 to 1.25.

It is possible to control the weight-average molecular weight of the resulting resin by using a monoallyl compound such as o-allyl phenol, a monohydrosilane such as triethylhydrosilane or a monohydrosiloxane as the molecular weight modifier.

### [(B) Epoxy Compound]

The epoxy compound of component (B) is represented by formula (B1) below.

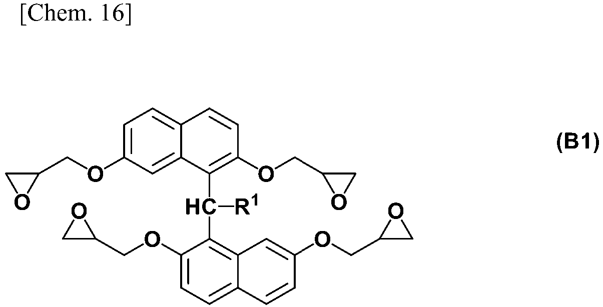

In formula (B1), R¹ is a hydrogen atom, a saturated hydrocarbyl group of 1 to 4 carbon atoms, a phenyl group, a hydroxyphenyl group or a halogen-substituted phenyl group.

The saturated hydrocarbyl group may be linear, branched or cyclic. Specific examples include methyl, ethyl, propyl and butyl groups.

R¹ is preferably a hydrogen atom, a methyl group or an ethyl group. A hydrogen atom or a methyl group is more preferred.

A commercial product may be used as the above alicyclic epoxy compound. Examples include HP-4700 and HP-4710 from DIC Corporation.

The component (B) content per 100 parts by weight of component (A) is preferably from 3 to 100 parts by weight, more preferably from 3 to 75 parts by weight, and even more preferably from 5 to 50 parts by weight. A component (B) content within this range is desirable because, when rendered into a dry film, a better coating film can be obtained. Component (B) may be a single epoxy compound used alone or two or more may be used in combination.

### [(C) Photoacid Generator]

The photoacid generator of component (C) is not particularly limited so long as it is a compound which decomposes when irradiated with light and generates an acid, although one which decomposes under the effect of 190 to 500 nm wavelength light and generates an acid is preferred. This photoacid generator serves as a curing catalyst. The photosensitive resin composition of the invention has an excellent photoacid generator compatibility, enabling a broad range of photoacid generators to be used.

The photoacid generator is exemplified by onium salts, diazomethane derivatives, glyoxime derivatives, β-ketosulfone derivatives, disulfone derivatives, nitrobenzylsulfonate derivatives, sulfonic acid ester derivatives, imide-yl-sulfonate derivatives, oxime sulfonate derivatives and iminosulfonate derivatives.

Examples of the onium salts include sulfonium salts of formula (C1) below and iodonium salts of formula (C2) below.

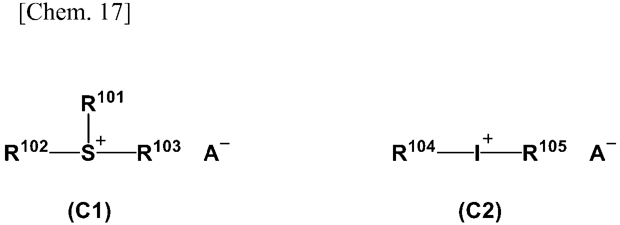

In formulas (C1) and (C2), R¹⁰¹ to R¹⁰⁵ are each independently a saturated hydrocarbyl group of 1 to 12 carbon atoms which may have a substituent, an aryl group of 6 to 12 carbon atoms which may have a substituent, or an aralkyl group of 7 to 12 carbon atoms which may have a substituent. A⁻ is a non-nucleophilic counterion.

The saturated hydrocarbyl group may be linear, branched or cyclic. Specific examples include alkyl groups such as methyl, ethyl, propyl, butyl, pentyl and hexyl groups, as well as structural isomers of these; and cyclic saturated hydrocarbyl groups such as cyclopropyl, cyclobutyl, cyclopentyl, cyclohexyl, norbornyl and adamantyl groups. Examples of the aryl groups include phenyl, naphthyl and biphenylyl groups. Examples of the aralkyl groups include benzyl and phenethyl groups.

The substituents are exemplified by the oxo group, saturated hydrocarbyl groups of 1 to 12 carbon atoms, saturated hydrocarbyloxy groups of 1 to 12 carbon atoms, aryl groups of 6 to 24 carbon atoms, aralkyl groups of 7 to 25 carbon atoms, aryloxy groups of 6 to 24 carbon atoms and arylthiol groups of 6 to 24 carbon atoms. The hydrocarbyl moiety in the saturated hydrocarbyl groups and saturated hydrocarbyloxy groups may be linear, branched or cyclic. Specific examples include the same as those mentioned above as examples of saturated hydrocarbyl groups represented by R¹⁰¹ to R^{105.}

Preferred examples of R¹⁰¹ to R¹⁰⁵ include saturated hydrocarbyl groups which may have a substituent, such as methyl, ethyl, propyl, butyl, cyclohexyl, norbornyl, adamantyl and 2-oxocyclohexyl groups; aryl groups which may have a substituent, such as phenyl, naphthyl, biphenylyl, 2-, 3- or 4-methoxyphenyl, 2-, 3- or 4-ethoxyphenyl, 3- or 4-tert-butoxyphenyl, 2-, 3- or 4-methylphenyl, 2-, 3- or 4-ethylphenyl, 4-tert-butylphenyl, 4-butylphenyl, dimethylphenyl, terphenylyl, biphenylyloxyphenyl and biphenylylthiophenyl groups; and aralkyl groups which may have a substituent, such as benzyl and phenethyl groups. Of these, aryl groups which may have a substituent and aralkyl groups which may have a substituent are more preferred.

Examples of the non-nucleophilic counterion include halide ions such as chloride and bromide ions; fluoroalkanesulfonate ions such as the triflate ion, 1,1,1-trifluoroethanesulfonate ion and nonafluorobutanesulfonate ion; arylsulfonate ions such as the tosylate ion, benzenesulfonate ion, 4-fluorobenzenesulfonate ion and 1,2,3,4,5-pentafluorobenzenesulfonate ion; alkanesulfonate ions such as the mesylate ion and butanesulfonate ion; fluoroalkanesulfonimide ions such as the trifluoromethanesulfonimide ion; fluoroalkanesulfonylmethide ions such as the tris(trifluoromethanesulfonyl)methide ion; borate ions such as the tetrakisphenylborate ion and tetrakis(pentafluorophenyl)borate ion; and phosphate ions such as hexafluorophosphate ion and tris(pentafluoroethyl)trifluorophosphate ion.

Examples of the diazomethane derivatives include compounds of formula (C3) below.

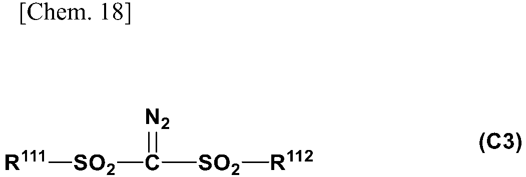

In formula (C3), R¹¹¹ and R¹¹² are each independently a saturated hydrocarbyl group of 1 to 12 carbon atoms, a halogenated saturated hydrocarbyl group of 1 to 12 carbon atoms, an aryl group of 6 to 12 carbon atoms which may have a substituent or an aralkyl group of 7 to 12 carbon atoms.

The saturated hydrocarbyl group may be linear, branched or cyclic. Specific examples include the same as those mentioned above as examples of saturated hydrocarbyl groups represented by R¹⁰¹ to R¹⁰⁵. Examples of the halogenated saturated hydrocarbyl group include trifluoromethyl, 1,1,1-trifluoroethyl, 1,1,1-trichloroethyl and nonafluorobutyl groups.

Examples of the aryl group which may have a substituent include the phenyl group; alkoxyphenyl groups such as 2-, 3- or 4-methoxyphenyl, 2-, 3- or 4-ethoxyphenyl and 3- or 4-tert-butoxyphenyl groups; alkylphenyl groups such as 2-, 3- or 4-methylphenyl, 2-, 3- or 4-ethylphenyl, 4-tert-butylphenyl, 4-butylphenyl and dimethylphenyl groups; and halogenated aryl groups such as fluorophenyl, chlorophenyl and 1,2,3,4,5-pentafluorophenyl groups. Examples of the aralkyl groups include benzyl and phenethyl groups.

Examples of the onium salt include diphenyliodonium trifluoromethanesulfonate, (p-tert-butoxyphenyl)phenyliodonium trifluoromethanesulfonate, diphenyliodonium p-toluenesulfonate, (p-tert-butoxyphenyl)phenyliodonium p-toluenesulfonate, triphenylsulfonium trifluoromethanesulfonate, (p-tert-butoxyphenyl)diphenylsulfonium trifluoromethanesulfonate, bis(p-tert-butoxyphenyl)phenylsulfonium trifluoromethanesulfonate, tris(p-tert-butoxyphenyl)sulfonium trifluoromethanesulfonate, triphenylsulfonium p-toluenesulfonate, (p-tert-butoxyphenyl)diphenylsulfonium p-toluenesulfonate, bis(p-tert-butoxyphenyl)phenylsulfonium p-toluenesulfonate, tris(p-tert-butoxyphenyl)sulfonium p-toluenesulfonate, triphenylsulfonium nonafluorobutanesulfonate, triphenylsulfonium butanesulfonate, trimethylsulfonium trifluoromethanesulfonate, trimethylsulfonium p-toluenesulfonate, cyclohexylmethyl(2-oxocyclohexyl)sulfonium trifluoromethanesulfonate, cyclohexylmethyl(2-oxocyclohexyl)sulfonium p-toluenesulfonate, dimethylphenylsulfonium trifluoromethanesulfonate, dimethylphenylsulfonium p-toluenesulfonate, dicyclohexylphenylsulfonium trifluoromethanesulfonate, dicyclohexylphenylsulfonium p-toluenesulfonate, bis(4-tert-butylphenyl)iodonium hexafluorophosphate, 4-(phenylthiol)phenyldiphenylsulfonium tris(pentafluoroethyl)trifluorophosphate, diphenyl(4-thiophenoxyphenyl)sulfonium hexafluoroantimonate, [4-(4-biphenylylthio)phenyl]-4-biphenylylsulfonium tris(trifluoromethanesulfonyl)methide, triphenylsulfonium tetrakis(fluorophenyl)borate, tris[4-(4-acetylphenyl)thiophenyl]sulfonium tetrakis(fluorophenyl)borate, triphenylsulfonium tetrakis(pentafluorophenyl)borate and tris[4-(4-acetylphenyl)thiophenyl]sulfonium tetrakis(pentafluorophenyl)borate.

Specific examples of the diazomethane derivative include bis(benzenesulfonyl) diazomethane, bis(p-toluenesulfonyl) diazomethane, bis(xylenesulfonyl) diazomethane, bis(cyclohexylsulfonyl) diazomethane, bis(cyclopentylsulfonyl) diazomethane, bis(n-butylsulfonyl) diazomethane, bis(isobutylsulfonyl) diazomethane, bis(sec-butylsulfonyl) diazomethane, bis(n-propylsulfonyl) diazomethane, bis(isopropylsulfonyl) diazomethane, bis(tert-butylsulfonyl) diazomethane, bis(n-pentylsulfonyl) diazomethane, bis(isopentylsulfonyl) diazomethane, bis(sec-pentylsulfonyl) diazomethane, bis(tert-pentylsulfonyl) diazomethane, 1-cyclohexylsulfonyl-1-(tert-butylsulfonyl) diazomethane, 1-cyclohexylsulfonyl-1-(tert-pentylsulfonyl) diazomethane and 1-tert-pentylsulfonyl-1-(tert-butylsulfonyl) diazomethane.

Specific examples of the glyoxime derivative include bis-o-(p-toluenesulfonyl)-α-dimethylglyoxime, bis-o-(p-toluenesulfonyl)-α-diphenylglyoxime, bis-o-(p-toluenesulfonyl)-α-dicyclohexylglyoxime, bis-o-(p-toluenesulfonyl)-2,3-pentanedione glyoxime, bis-(p-toluenesulfonyl)-2-methyl-3,4-pentanedione glyoxime, bis-o-(n-butanesulfonyl)-α-dimethylglyoxime, bis-o-(n-butanesulfonyl)-α-diphenylglyoxime, bis-o-(n-butanesulfonyl)-α-dicyclohexylglyoxime, bis-o-(n-butanesulfonyl)-2,3-pentanedione glyoxime, bis-o-(n-butanesulfonyl)-2-methyl-3,4-pentanedione glyoxime, bis-o-(methanesulfonyl)-α-dimethylglyoxime, bis-o-(trifluoromethanesulfonyl)-α-dimethylglyoxime, bis-o-(1,1,1-trifluoroethanesulfonyl)-α-dimethylglyoxime, bis-o-(tert-butanesulfonyl)-α-dimethylglyoxime, bis-o-(perfluorooctanesulfonyl)-α-dimethylglyoxime, bis-o-(cyclohexanesulfonyl)-α-dimethylglyoxime, bis-o-(benzenesulfonyl)-α-dimethylglyoxime, bis-o-(p-fluorobenzenesulfonyl)-α-dimethylglyoxime, bis-o-(p-tert-butylbenzenesulfonyl)-α-dimethylglyoxime, bis-o-(xylenesulfonyl)-α-dimethylglyoxime and bis-o-(camphorsulfonyl)-α-dimethylglyoxime.

Specific examples of the β-ketosulfone derivative include 2-cyclohexylcarbonyl-2-(p-toluenesulfonyl)propane and 2-isopropylcarbonyl-2-(p-toluenesulfonyl)propane.

Specific examples of the disulfone derivative include diphenyldisulfone and dicyclohexyldisulfone.

Specific examples of the nitrobenzyl sulfonate derivative include 2,6-dinitrobenzyl p-toluenesulfonate and 2,4-dinitrobenzyl p-toluenesulfonate.

Specific examples of the sulfonic acid ester derivative include 1,2,3-tris(methanesulfonyloxy)benzene, 1,2,3-tris(trifluoromethanesulfonyloxy)benzene and 1,2,3-tris(p-toluenesulfonyloxy)benzene.

Specific examples of the imide-yl-sulfonate derivative include phthalimide-yl-triflate, phthalimide-yl-tosylate, 5-norbornene-2,3-dicarboxyimide-yl-triflate, 5-norbornene-2,3-dicarboxyimide-yl-tosylate, 5-norbornene-2,3-dicarboxyimide-yl-n-butylsulfonate and n-trifluoromethylsulfonyloxy naphthylamide.

Specific examples of the oxime sulfonate derivative include α-(benzenesulfonium oximino)-4-methylphenyl acetonitrile and α-(p-tolylsulfonium oximino)-4-methylphenyl acetonitrile.

Specific examples of the iminosulfonate derivative include (5-(4-methylphenyl)sulfonyloximino-5H-thiophen-2-yldene)-(2-methylphenyl)acetonitrile and (5-(4-(4-methylphenylsulfonyloxy)phenylsulfonyloximino)-5H-thiophen-2-yldene)-(2-methylphenyl)acetonitrile.

2-Methyl-2-[(4-methylphenyl)sulfonyl]-1-[(4-methylthio)phenyl]-1-propane and the like may also be suitably used.

From the standpoint of the photocurability, the component (C) content per 100 parts by weight of component (A) is preferably from 0.05 to 20 parts by weight, and more preferably from 0.05 to 5 parts by weight. At a component (C) content of 0.05 part by weight or more, sufficient acid is generated and the crosslinking reaction fully proceeds; at 20 parts by weight or less, an increase in the light absorbance by the photoacid generator itself can be suppressed, which is desirable because there is no risk of a decline in transparency. Component (C) may be a single photoacid generator used alone, or two more photoacid generators may be used in combination.

### [(D) Crosslinking Agent]

The photosensitive resin composition of the invention preferably includes also, as component (D), a crosslinking agent. The crosslinking agent is an ingredient for inducing condensation reactions with phenolic hydroxyl groups on above component (A) or saturated hydrocarbyloxy groups represented by R¹³, R¹⁴, R²³ or R²⁴ and thus facilitating pattern formation. In addition, it further increases the strength of the cured product.

Preferred examples of the crosslinking agent include melamine compounds, guanamine compounds, glycoluril compounds and urea compounds having an average of two or more methylol groups and/or alkoxymethyl groups per molecule; amino condensation products modified with formaldehyde or formaldehyde-alcohol; phenol compounds having an average of two or more methylol groups or alkoxymethyl groups per molecule; and epoxy compounds having an average of two or more epoxy groups per molecule.

The melamine compound is exemplified by compounds of formula (D1) below.

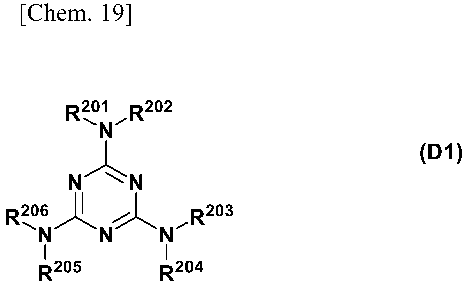

In formula (D), R²⁰¹ to R²⁰⁶ are each independently a methylol group, a saturated hydrocarbyloxymethyl group of 2 to 5 carbon atoms or a hydrogen atom, with at least one being a methylol group or saturated hydrocarbyloxymethyl group. Examples of the saturated hydrocarbyloxymethyl group include alkoxymethyl groups such as the methoxymethyl and ethoxymethyl groups.

Examples of the melamine compound of formula (D1) include trimethoxymethylmonomethylolmelamine, dimethoxymethylmonomethylolmelamine, trimethylolmelamine, hexamethylolmelamine, hexamethoxymethylmelamine and hexaethoxymethylmelamine.

The melamine compound of formula (D1) can be obtained by first modifying a melamine monomer by methylolation with formaldehyde according to a known method, and additionally modifying this by alkoxylation with an alcohol. The alcohol is preferably a lower alcohol, such as an alcohol of 1 to 4 carbon atoms.

Examples of the guanamine compounds include tetramethylolguanamine, tetramethoxymethylguanamine and tetramethoxyethylguanamine.

Examples of the glycoluril compound include tetramethylolglycoluril and tetrakis(methoxymethyl)glycoluril.

Examples of the urea compounds include tetramethylolurea, tetramethoxymethylurea, tetramethoxyethylurea, tetraethoxymethylurea and tetrapropoxymethylurea.

Examples of the amino condensation products modified with formaldehyde or formaldehyde-alcohol include melamine condensation products modified with formaldehyde or formaldehyde-alcohol and urea condensation products modified with formaldehyde or formaldehyde-alcohol.

Examples of the modified melamine condensation products include those obtained by addition condensation polymerizing a compound of formula (D1) or an oligomer thereof (e.g., an oligomer such as a dimer or trimer) with formaldehyde to the desired molecular weight. A hitherto known process may be employed as the addition condensation polymerization process. The modified melamine represented by formula (D1) may be a single compound used alone or two or more may be used in combination.

Examples of urea condensation products modified with formaldehyde or formaldehyde-alcohol include methoxymethylated urea condensation products, ethoxymethylated urea condensation products and propoxymethylated urea condensation products.

The modified urea condensation product can be obtained in accordance with a known process by modifying a urea condensation product of the desired molecular weight with formaldehyde via methylolation, or by additionally modifying this with an alcohol via alkoxylation.

Examples of phenol compounds having an average of two or more methylol groups or alkoxymethyl groups per molecule include (2-hydroxy-5-methyl)-1,3-benzenedimethanol and 2,2',6,6'-tetramethoxymethylbisphenol A.

Examples of epoxy compounds having an average of two or more epoxy groups per molecule include bisphenol epoxy resins such as bisphenol A epoxy resins and bisphenol F epoxy resins; novolac epoxy resins such as phenolic novolac epoxy resins and cresol novolac epoxy resins; and triphenolalkane epoxy resins, biphenyl epoxy resins, dicyclopentadiene-modified phenolic novolac epoxy resins, phenolic aralkyl epoxy resins, biphenylaralkyl epoxy resins, naphthalene ring-containing epoxy resins, glycidyl ester epoxy resins, alicyclic epoxy resins and heterocyclic epoxy resins.

When component (D) is included, the content thereof per 100 parts by weight of component (A) is preferably from 0.5 to 50 parts by weight, and more preferably from 1 to 30 parts by weight. At 0.5 part by weight or more, sufficient curability can be obtained during light irradiation; at 50 parts by weight or less, the ratio of component (A) in the photosensitive resin composition does not decrease, and so satisfactory effects can be manifested in the cured product. Component (D) may be a single crosslinking agent used alone, or two or more may be used in admixture.

### [(E) Solvent]

The photosensitive resin composition of the invention may include a solvent as component (E). The solvent is not particularly limited, provided that it is a solvent capable of dissolving components (A) to (D) and the various additives that are subsequently described. However, organic solvents are preferred because of their excellent ability to dissolve these ingredients.

Examples of the organic solvent include ketones such as cyclohexanone, cyclopentanone and methyl-2-n-pentyl ketone; alcohols such as 3-methoxybutanol, 3-methyl-3-methoxybutane, 1-methoxy-2-propanol and 1-ethoxy-2-propanol; ethers such as propylene glycol monomethyl ether (PGME), ethylene glycol monomethyl ether, propylene glycol monoethyl ether, ethylene glycol monoethyl ether, propylene glycol dimethyl ether and diethylene glycol dimethyl ether; and esters such as propylene glycol monomethyl ether acetate (PGMEA), propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, propylene glycol mono-tert-butyl ether acetate and γ-butyrolactone. In particular, ethyl lactate, cyclohexanone, cyclopentanone, PGMEA, γ-butyrolactone and mixtures thereof, all of which have an outstanding ability to dissolve photoacid generators, are preferred.

From the standpoint of the compatibility and viscosity of the photosensitive resin composition, the amount of component (E) used per 100 parts by weight of component (A) is preferably from 50 to 2,000 parts by weight, more preferably from 50 to 1,000 parts by weight, and most preferably from 50 to 100 parts by weight. Component (E) may be a single solvent used alone, or two or more solvents may be used in combination.

### [Other Additives]

In addition to the various above ingredients, the photosensitive resin composition of the invention may also include other additives. The other additives are exemplified by commonly used surfactants for improving the coating properties.

The surfactants are preferably nonionic compounds. Examples include fluorocarbon surfactants, including perfluoroalkyl polyoxyethylene ethanol, fluorinated alkyl esters, perfluoroalkyl amine oxides and fluorine-containing organosiloxane compounds. Commercial products such as the following may be used as these: Fluorad^{®} FC-430 (from 3M Company), Surflon^{®} S-141 and S-145 (AGC Seimi Chemical Co., Ltd.), Unidyne^{®} DS-401, DS-4031 and DS-451 (Daikin Industries, Ltd.), Megaface^{®} F-8151 (DIC Corporation) and X-70-093 (Shin-Etsu Chemical Co., Ltd.). Of these, Fluorad FC-430 and X-70-093 are preferred. The content of this surfactant is preferably from 0.05 to 1 part by weight per 100 parts by weight of component (A).

The photosensitive resin composition of the invention may include, as another additive, a silane coupling agent. By including a silane coupling agent, adhesion of the coating film obtained from this composition to the adherend can be further increased. Exemplary silane coupling agents include epoxy group-containing silane coupling agents and aromatic group-containing aminosilane coupling agents. These may be used singly or two or more may be used in combination. The content of the silane coupling agent is not particularly limited, although when included in the photosensitive resin composition of the invention, the content is preferably from 0.01 to 5 wt%.

Preparation of the photosensitive resin composition of the invention is carried out by a conventional method. For example, the photosensitive resin composition of the invention can be prepared by stirring and mixing together the various above ingredients and then, if necessary, removing solid matter by filtering the mixture using a filter or the like.

The photosensitive resin composition of the invention that has been prepared in this way can be suitably used as a protective film for semiconductor devices, a protective film for wiring, a coverlay film, a solder mask, an insulating film for through electrodes (for TSVs), and also as an adhesive between layered substrates in three-dimensional lamination.

### [Method of Patterning with Photosensitive Resin Composition]

A patterning method that uses the photosensitive resin composition of the invention includes the following steps:
(i) forming a photosensitive resin coating film on a substrate by using the photosensitive resin composition of the invention,
(ii) exposing the photosensitive resin coating film to light, and
(iii) patterning the exposed photosensitive resin coating film by development with a developer.

Step (i) uses the photosensitive resin composition to form a photosensitive resin coating film on a substrate. Examples of the substrate include silicon wafers, through-electrode silicon wafers, silicon wafers thinned by back-side grinding, plastic or ceramic substrates, and substrates that are partially or entirely covered with a metal such as nickel or gold by ion sputtering or plating. Uneven substrates are also sometimes used.

The method of forming a photosensitive resin coating film is exemplified by, for example, applying the photosensitive resin composition onto a substrate and, if necessary, carrying out a prebake. Application may be carried out by a known method, such as dip coating, spin coating or roll coating. The photosensitive resin composition is applied in an amount which may be suitably selected according to the intended object, although application such that the resulting photosensitive resin coating film has a thickness of preferably from 0.1 to 200 µm, and more preferably from 1 to 150 µm, is desirable.

To enhance the film thickness uniformity at the substrate surface, a solvent may be added dropwise to the substrate (prewetting) prior to application of the photosensitive resin composition. The solvent thus added and the amount thereof can be suitably selected according to the intended purpose. Preferred examples of the solvent include alcohols such as isopropyl alcohol (IPA), ketones such as cyclohexanone, and glycols such as PGME. The solvent used in the photosensitive resin composition may also be used.

Here, to efficiently carry out the photocuring reaction, if necessary, the solvent, etc. may be evaporated beforehand by carrying out a prebake. The prebake can be carried out at, for example, between 40°C and 140°C for a period of from 1 minute to one hour.

Next, (ii) the photosensitive resin coating film is exposed to light. Exposure at this time is preferably carried out with light having a wavelength of from 10 to 600 nm, and more preferably with 190 to 500 nm wavelength light. Examples of light having such a wavelength include light of various wavelengths generated by a radiation generating device, such as ultraviolet radiation (e.g., the g-line, h-line or i-line) and far-ultraviolet radiation (248 nm, 193 nm). Of these, light having a wavelength of 248 to 436 nm is especially preferred. The exposure dose is preferably from 10 to 10,000 mJ/cm².

Exposure may be carried out through a photomask. The photomask may be, for example, one in which the desired pattern has been cut out. The photomask material is not particularly limited, although one which shields out light of the above wavelength is preferred. For example, a material having a light-shielding film of chromium or the like may be suitably used.

In addition, to increase the development sensitivity, it is desirable to carry out a post-exposure bake (PEB). PEB is preferably carried out at between 40°C and 150°C for a period of 0.5 to 10 minutes. With PEB, the light-exposed areas crosslink, forming an insolubilized pattern that is insoluble in the organic solvent serving as the developer.

Following exposure or PEB, (iii) the photosensitive resin coating film is patterned by development with a developer. Organic solvents, including alcohols such as IPA, ketones such as cyclohexanone and glycols such as PGME, are preferred as the developer, although the solvent used in the photosensitive resin composition may also be used. The method of development may be a conventional method, such as that of dipping the patterned substrate in the developer. Unexposed areas are dissolved and removed by organic solvent development, thereby forming a pattern. After this, where necessary, washing, rinsing, drying and the like are carried out, giving a resin coating film having the desired pattern.

Additionally, (iv) the patterned film may be post-cured at preferably between 100°C and 250°C, more preferably between 130°C and 220°C, using an oven or a hot plate. At a post-curing temperature of between 100°C and 250°C, the crosslink density of the photosensitive resin composition is increased, enabling remaining volatile ingredients to be removed, which is advantageous from the standpoint of the adhesion to the substrate, heat resistance, strength, electrical characteristics and also bond strength. The post-curing time is preferably from 10 minutes to 10 hours, and more preferably from 10 minutes to 3 hours. By using the photosensitive resin composition of the invention, a coating film having various excellent film properties can be obtained even with a relatively low-temperature post-cure at 200°C or below. The thickness of the post-cured coating film (cured coating film) is generally from 1 to 200 µm, and preferably from 5 to 50 µm.

In cases where there is no need to form a pattern, such as when one wishes to form simply a uniform coating film, film formation may be carried out by, in step (ii) of the above patterning process, exposing the photosensitive resin coating film to light of a suitable wavelength light without passing through the photomask.

### [Substrate Bonding Method]

The photosensitive resin composition of the invention can also be used as an adhesive for bonding two substrates. The substrate bonding method is exemplified by a method which bonds, under suitable heat and pressure conditions, a substrate on which has been formed a coating film of the inventive photosensitive resin composition with a second substrate in such manner that an adhesive bond forms between the two substrates. Either or both of the substrate on which a coating film has been formed and the second substrate are sometimes singulated into chips by dicing or the like. The bonding conditions are preferably a heating temperature of between 50°C and 200°C and a period of from 1 to 60 minutes. Wafers may be bonded to each other under reduced pressure while applying a load using a wafer bonder as the bonding device, or chip-wafer or chip-chip bonding using a flip chip bonder may be carried out. The bond strength of the adhesive layer that has been formed between the substrates increases with the subsequently described post-cure, resulting in permanent adhesion.

By post-curing under the same conditions as in above Step (iv) the substrates on which attachment (bonding) has been carried out, the crosslink density of the coating film rises, enabling the substrate bond strength to be increased. Crosslinking reactions arise due to heating during bonding, but because side reactions accompanied by gas evolution do not occur with these crosslinking reactions, particularly when used as a substrate adhesive, the photosensitive resin composition does not lead to attachment defects (voids).

### [Photosensitive Dry Film]

The photosensitive dry film of the invention has a support film and, on the support film, a photosensitive resin coating film obtained from the above-described photosensitive resin composition.

The photosensitive dry film (support film and photosensitive resin coating film) is a solid. Because the photosensitive resin coating film does not include a solvent, there is no risk of bubbles caused by solvent volatilization remaining within the photosensitive resin coating film and between the coating film and an uneven substrate.

From the standpoint of the flatness, step coverage and substrate stacking interval on an uneven substrate, the photosensitive resin coating film has a thickness of preferably from 5 to 200 µm, and more preferably from 10 to 100 µm.

The viscosity and flowability of the photosensitive resin coating film are closely related. Within a suitable viscosity range, the photosensitive resin coating film can exhibit suitable flowability, enabling penetration deep into narrow gaps and, with softening of the resin, enabling adhesion with the substrate to be strengthened. Therefore, from the standpoint of its flowability, the photosensitive resin coating film has a viscosity at between 80°C and 120°C which is preferably from 10 to 5,000 Pa·s, more preferably from 30 to 2,000 Pa·s, and even more preferably from 50 to 300 Pa·s. In this invention, viscosity is a measured value obtained with a rotational viscometer.

When the photosensitive dry film of the invention is bonded to an uneven substrate, the photosensitive resin coating film conforms to and covers the uneven features, enabling a high flatness to be achieved. In particular, this photosensitive resin coating film is characterized by a low viscoelasticity, enabling an even higher flatness to be achieved. Furthermore, when the photosensitive resin coating film is bonded to the substrate in a vacuum environment, the formation of gaps therebetween can be more effectively prevented.

The photosensitive dry film of the invention can be produced by applying the photosensitive resin composition onto a support film and drying the applied composition to form a photosensitive resin coating film. A film coater commonly used for producing pressure-sensitive adhesive products can be used as the photosensitive dry film manufacturing apparatus. Examples of such film coaters include comma coaters, comma reverse coaters, multi-coaters, die coaters, lip coaters, lip reverse coaters, direct gravure coaters, offset gravure coaters, three-roll bottom reverse coaters and four-roll bottom reverse coaters.

The photosensitive dry film can be produced by unwinding a support film from the unwind shaft of the film coater and passing it through the coater head of the film coater while coating the support film with the photosensitive resin composition to a predetermined thickness, and subsequently passing the support film with photosensitive resin composition thereon through a circulating hot-air oven at a predetermined temperature for a predetermined length of time so as to dry the composition on the support film and thereby form a photosensitive resin coating film. Alternatively, where necessary, a photosensitive dry film with protective film can be produced by passing the photosensitive dry film, together with a protective film that has been unwound from another unwind shaft of the film coater, through a laminate roll under a predetermined pressure and laminating the photosensitive resin coating film on the support film with the protective film, then winding the resulting laminate onto the take-up shaft of the film coater. In this case, the temperature is preferably between 25°C and 150°C, the time is preferably from 1 to 100 minutes, and the pressure is preferably from 0.01 to 5 MPa.

The support film may be a one-layer film composed of a single film, or may be a multilayer film in which a plurality of films are laminated. Examples of the film material include synthetic resins such as polyethylene, polypropylene, polycarbonate and polyethylene terephthalate. Of these, for a suitable flexibility, mechanical strength and heat resistance, polyethylene terephthalate is preferred. These films may be ones which have been subjected to various treatments, such as corona treatment or the application of a stripping agent. Commercial products may be used as these films. Examples include Cerapeel WZ(RX) and Cerapeel BX8(R) (from Toray Advanced Film Co., Ltd.), E7302 and E7304 (Toyobo Co., Ltd.), Purex G31 and Purex G71T1 (Teijin Dupont Film Japan Ltd.), and PET38×1-A3, PET38×1-V8 and PET38×1-X08 (from Nippa Co., Ltd.).

A film similar to the above-described support film may be used as the protective film. Polyethylene terephthalate and polyethylene are preferred because they have a suitable flexibility. Commercial products may be used as the protective film. Examples of polyethylene terephthalate protective films include those already mentioned; examples of polyethylene protective films include GF-8 (Tamapoly Co., Ltd.) and PE Film 0 Type (Nippa Co., Ltd.).

From the standpoint of the stability of photosensitive dry film production, the tendency of the film to retain the curvature of the roll core, and curl prevention, the support film and the protective film both have thicknesses of preferably from 10 to 100 µm, and more preferably from 25 to 50 µm.

### [Method of Patterning with Photosensitive Dry Film]

The method of patterning using the photosensitive dry film of the invention includes the steps of:
(i') forming a photosensitive resin coating film on a substrate by using the photosensitive dry film of the invention,
(ii) exposing the photosensitive resin coating film to light, and
(iii) patterning the exposed photosensitive resin coating film by development with a developer.

First, Step (I') uses a photosensitive dry film to form a photosensitive resin coating film on a substrate. Specifically, a photosensitive resin coating film is formed on a substrate by attaching the photosensitive resin coating film of a photosensitive dry film to the substrate. Or, in cases where the photosensitive dry film has a protective film, the protective film is peeled from the photosensitive dry film, following which the photosensitive resin coating film of the photosensitive dry film is attached to the substrate. Attachment may be carried out using, for example, a film laminator.

The substrate is exemplified by the same substrates as those mentioned above in connection with the method of patterning using a photosensitive resin composition. The film laminator is preferably a vacuum laminator. For example, the film laminator peels off the protective film on the photosensitive dry film and, within a vacuum chamber under a given vacuum, uses a laminating roll having a given pressure to bond the now exposed photosensitive resin coating film to the substrate on a table at a given temperature The temperature is preferably between 60°C and 120°C, the pressure is preferably from 0 to 5.0 MPa, and the degree of vacuum is preferably from 50 to 500 Pa.

In order to obtain a photosensitive resin coating film of the required thickness, if necessary, the film may be laminated a plurality of times. At a number of laminations of, for example, from 1 to about 10, a photosensitive resin coating film having a thickness of about 10 µm to about 1,000 µm, especially from about 100 µm to about 500 µm, can be obtained.

If necessary, a prebake may be carried out so as to efficiently carry out the photocuring reaction on the photosensitive resin coating film and so as to improve adhesion between the photosensitive resin coating layer and the substrate. The prebake may be carried out at, for example, between 40°C and 140°C for a period of from about 1 minute to about 1 hour.

As in the method of patterning using the photosensitive resin composition, the photosensitive resin coating film that has been laminated to the substrate can be patterned by the steps of: (ii) exposing the photosensitive resin coating film to light, (iii) forming a pattern by developing the exposed photosensitive resin coating film with a developer, and, if necessary, (iv) carrying out post-curing treatment. The support film of the photosensitive dry film, depending on the process, is peeled before the prebake or before PEB, or is removed by another method.

The coating film obtained from the photosensitive resin composition and the photosensitive dry film is endowed with mechanical properties such as solder resistance, heat resistance, low susceptibility to substrate warpage and cracking resistance, and has excellent copper migration resistance and excellent adhesion to substrates and the like, making it suitable for use as a protective film for electrical and electronic components such as semiconductor devices and as a substrate bonding film.

### EXAMPLES

Synthesis Examples, Examples of the invention and Comparative Examples are given below by way of illustration, although the invention is not limited by these Examples. Weight-average molecular weights (Mw) were measured by gel permeation chromatography (GPC) against a monodisperse polystyrene standard under the following conditions: TSKgel Super HZM-H column (Tosoh Corporation); flow rate, 0.6 mL/min; eluting solvent, THF; column temperature, 40°C.

Compounds (S-1) to (S-6) used in the Synthesis Examples are shown below.

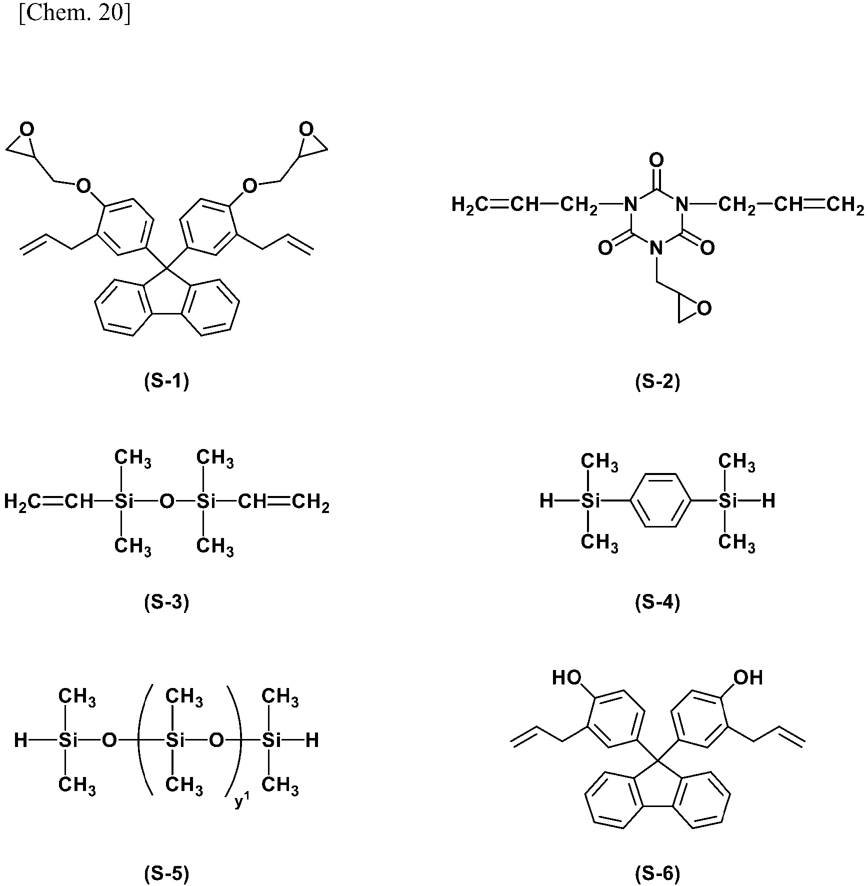

### [1] Synthesis of Silicone Resins

### [Synthesis Example 1]

A three-liter flask equipped with a stirrer, a thermometer, a nitrogen purging system and a reflux condenser was charged with 215.0 g (0.5 mol) of Compound (S-6), following which 2,000 g of toluene was added and the flask contents were heated to 70°C. Next, 1.0 g of a toluene solution of chloroplatinic acid (platinum concentration, 0.5 wt%) was poured in and 67.9 g (0.35 mol) of Compound (S-4) and 453.0 g (0.15 mol) of Compound (S-5) (y¹ = 40, from Shin-Etsu Chemical Co., Ltd.) were added dropwise over one hour (sum of hydrosilyl groups/sum of alkenyl groups = 1/1 (molar ratio)). Following the completion of dropwise addition, the flask contents were heated to 100°C and aged for 6 hours, after which toluene was vacuum-distilled from the reaction solution, giving Silicone Resin A-1. Silicone Resin A-1 was confirmed from the ¹H-NMR spectrum (Bruker) to have recurring units a1, a2, b1 and b2. The weight-average molecular weight of Silicone Resin A-1 was 62,000, and the silicone content was 61.6 wt%.

### [Synthesis Example 2]

A three-liter flask equipped with a stirrer, a thermometer, a nitrogen purging system and a reflux condenser was charged with 53.00 g (0.20 mol) of Compound (S-2) and 117.6 g (0.30 mol) of Compound (S-1), following which 2,000 g of toluene was added and the flask contents were heated to 70°C. Next, 1.0 g of a toluene solution of chloroplatinic acid (platinum concentration, 0.5 wt%) was poured in and 48.5 g (0.25 mol) of Compound (S-4) and 755.0 g (0.25 mol) of Compound (S-5) (y¹ = 40, from Shin-Etsu Chemical Co., Ltd.) were added dropwise over one hour (sum of hydrosilyl groups/sum of alkenyl groups = 1/1 (molar ratio)). Following the completion of dropwise addition, the flask contents were heated to 100°C and aged for 6 hours, after which toluene was vacuum-distilled from the reaction solution, giving Silicone Resin A-2. Silicone Resin A-2 was confirmed from the ¹H-NMR spectrum (Bruker) to have recurring units a1, a3, a4, b1, b3 and b4. The weight-average molecular weight of Silicone Resin A-2 was 83,000, and the silicone content was 77.5 wt%.

### [Synthesis Example 3]

A three-liter flask equipped with a stirrer, a thermometer, a nitrogen purging system and a reflux condenser was charged with 27.9 g (0.15 mol) of Compound (S-3), 19.6 g (0.05 mol) of Compound (S-1) and 129.0 g (0.30 mol) of Compound (S-6), following which 2,000 g of toluene was added and the flask contents were heated to 70°C. Next, 1.0 g of a toluene solution of chloroplatinic acid (platinum concentration, 0.5 wt%) was poured in and 87.3 g (0.45 mol) of Compound (S-4) and 79.3 g (0.05 mol) of Compound (S-5) (y¹ = 40, from Shin-Etsu Chemical Co., Ltd.) were added dropwise over one hour (sum of hydrosilyl groups/sum of alkenyl groups = 1/1 (molar ratio)). Following the completion of dropwise addition, the flask contents were heated to 100°C and aged for 6 hours, after which toluene was vacuum-distilled from the reaction solution, giving Silicone Resin A-3. Silicone Resin A-3 was confirmed from the ¹H-NMR spectrum (Bruker) to have recurring units a1, a2, a4, b1, b2 and b4. The weight-average molecular weight of Silicone Resin A-3 was 24,000, and the silicone content was 31.2 wt%.

### [2] Preparation of Photosensitive Resin Composition

### [Examples 1-7 and Comparative Examples 1 to 20]

The photosensitive resin compositions in Examples 1 to 8 and Comparative Examples 1 to 20 were prepared by compounding the ingredients according to the formulations shown in Tables 1 to 3, then stirring and dissolving at room temperature, and subsequently carrying out microfiltration with a 1.0 µm Teflon^{®} filter.

**[Table 1]**

| Ingredients | | | Example | | | | | | |
|---|---|---|---|---|---|---|---|---|---|
| | | | 1 | 2 | 3 | 4 | 5 | 6 | 7 |
| (A) | Resin | A-1 | - | - | - | - | 100 | 100 | 100 |
| | | A-2 | 100 | - | 100 | - | - | - | - |
| | | A-3 | - | 100 | - | 100 | - | - | - |
| (B) | Epoxy compound | B-1 | 20 | - | - | 40 | - | 5 | - |
| | | B-2 | - | 20 | - | - | 40 | - | - |
| | | B-3 | - | - | 20 | - | - | - | 5 |
| (C) | Photoacid generator | PAG-1 | 1 | 1 | 1 | 3 | 3 | 2 | 2 |
| (D) | Crosslinking agent | CL-1 | - | - | - | 5 | 10 | 20 | 40 |
| (E) | Solvent | cyclopentanone | 55 | 55 | 55 | 55 | 55 | 55 | 55 |

**[Table 2]**

| Ingredients | | | Comparative Example | | | | | | | | | |
|---|---|---|---|---|---|---|---|---|---|---|---|---|
| | | | 1 | 2 | 3 | 4 | 5 | 6 | 7 | 8 | 9 | 10 |
| (A) | Resin | A-1 | 100 | - | - | 100 | - | - | 100 | - | - | 100 |
| | | A-2 | - | - | 100 | - | 100 | - | - | 100 | - | - |
| | | A-3 | - | 100 | - | - | - | 100 | - | - | 100 | - |
| | | A-1' | - | - | - | - | - | - | - | - | - | - |
| (B) | Epoxy compound | B-1 | - | - | - | - | - | - | - | - | - | - |
| | | B-3 | - | - | - | - | - | - | - | - | - | - |
| | | B-5 | - | - | 20 | - | - | - | - | - | - | - |
| | | B-6 | - | - | - | 20 | - | - | - | - | - | - |
| | | B-7 | - | - | - | - | 20 | - | - | - | - | - |
| | | B-8 | - | - | - | - | - | 20 | - | - | - | - |
| | | B-9 | - | - | - | - | - | - | 20 | - | - | - |
| | | B-10 | - | - | - | - | - | - | - | 20 | - | - |
| | | B-11 | - | - | - | - | - | - | - | - | 20 | - |
| | | B-12 | - | - | - | - | - | - | - | - | - | 20 |
| (C) | Photoacid generator | PAG-1 | 1 | 1 | 1 | 1 | 1 | 1 | 1 | 1 | 1 | 1 |
| (D) | Crosslinking agent | CL-1 | 40 | - | - | 20 | - | - | 20 | - | - | 10 |
| (E) | Solvent | cyclopentanone | 55 | 55 | 55 | 55 | 55 | 55 | 55 | 55 | 55 | 55 |

**[Table 3]**

| Ingredients | | | Comparative Example | | | | | | | | | |
|---|---|---|---|---|---|---|---|---|---|---|---|---|
| | | | 11 | 12 | 13 | 14 | 15 | 16 | 17 | 18 | 19 | 20 |
| (A) | Resin | A-1 | - | - | 100 | - | - | 100 | - | - | - | - |
| | | A-2 | 100 | - | - | 100 | - | - | 100 | - | - | - |
| | | A-3 | - | 100 | - | - | 100 | - | - | 100 | - | - |
| | | A-1' | - | - | - | - | - | - | - | - | 100 | 100 |
| (B) | Epoxy compound | B-1 | - | - | - | - | - | - | - | - | 20 | - |
| | | B-3 | - | - | - | - | - | - | - | - | - | 40 |
| | | B-5 | 40 | - | - | - | - | - | - | - | - | - |
| | | B-6 | - | 40 | - | - | - | - | - | - | - | - |
| | | B-7 | - | - | 40 | - | - | - | - | - | - | - |
| | | B-8 | - | - | - | 40 | - | - | - | - | - | - |
| | | B-9 | - | - | - | - | 40 | - | - | - | - | - |
| | | B-10 | - | - | - | - | - | 40 | - | - | - | - |
| | | B-11 | - | - | - | - | - | - | 40 | - | - | - |
| | | B-12 | - | - | - | - | - | - | - | 40 | - | - |
| (C) | Photoacid generator | PAG-1 | 3 | 3 | 3 | 3 | 3 | 3 | 3 | 3 | 1 | 1 |
| (D) | Crosslinking agent | CL-1 | - | - | 5 | - | - | 5 | - | - | 5 | 20 |
| (E) | Solvent | cyclopentanone | 55 | 55 | 55 | 55 | 55 | 55 | 55 | 55 | 55 | 55 |

In Tables 1 to 3, Epoxy Compounds B-1 to B-12 were as follows.

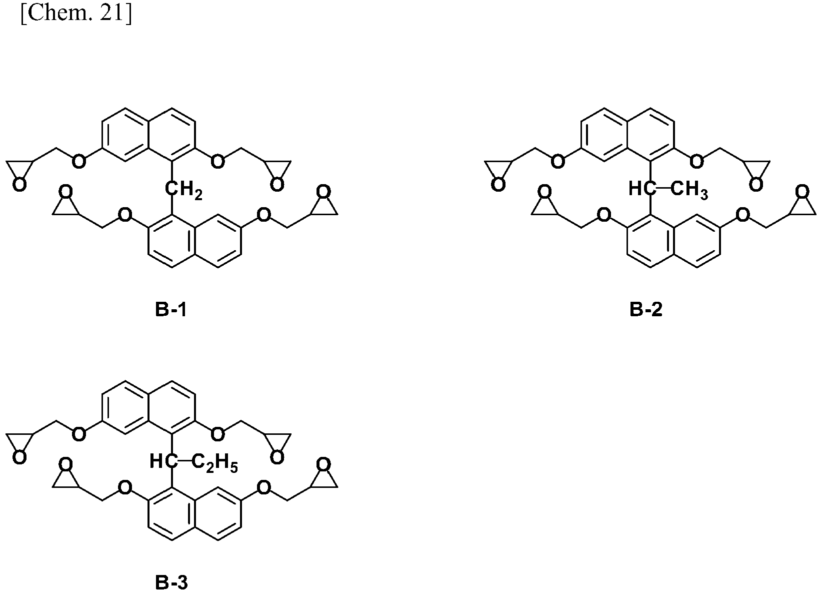

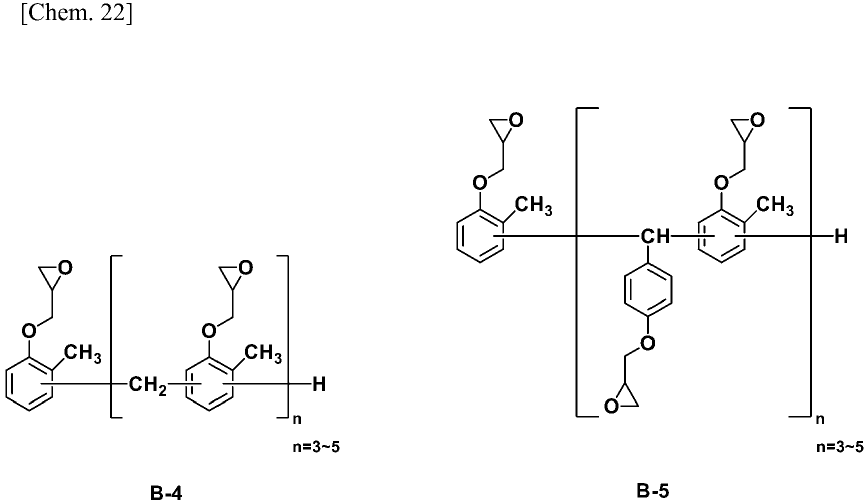

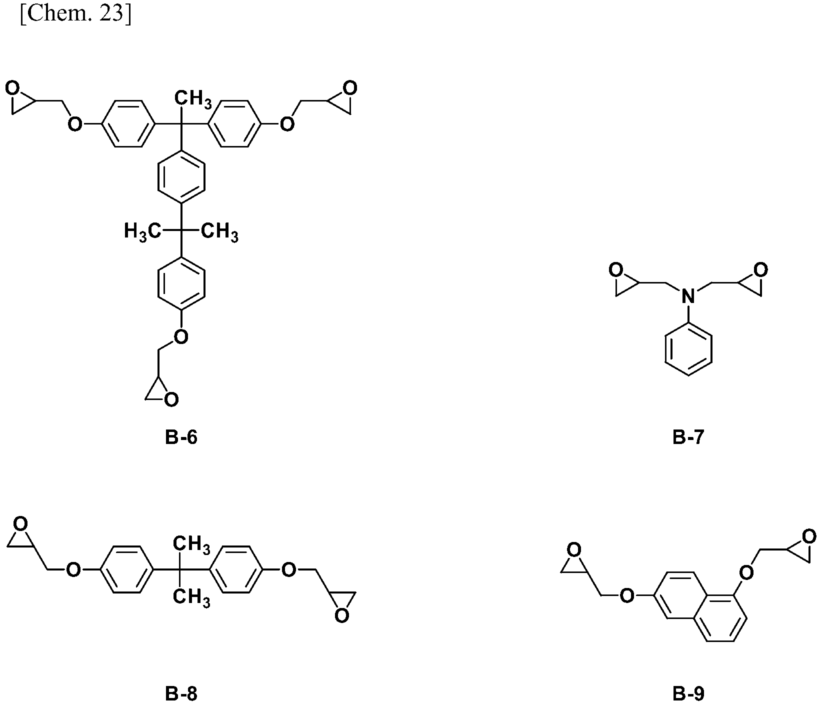

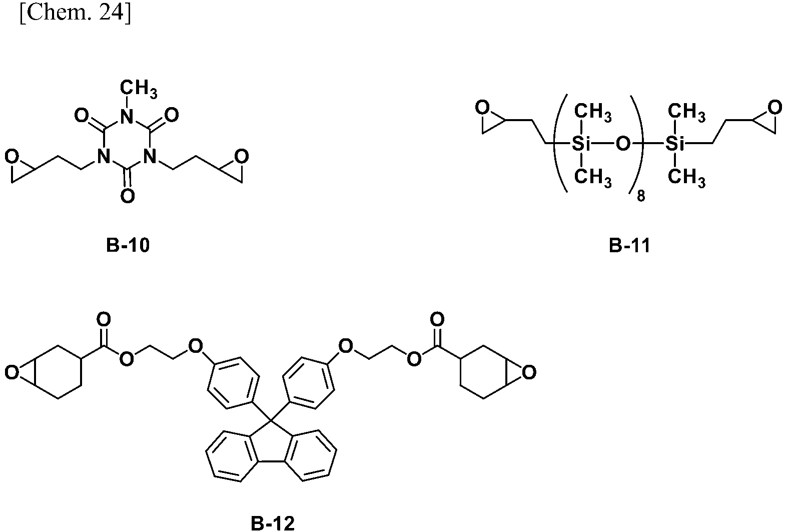

In Tables 1 to 3, Photoacid Generator PAG-1 is as follows.

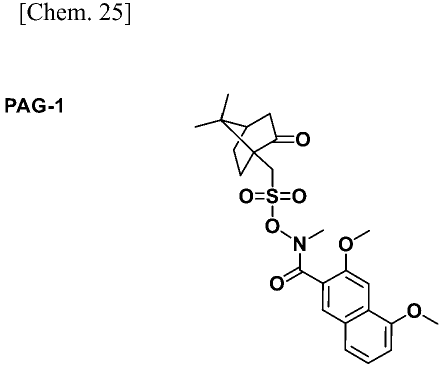

In Tables 1 to 3, Crosslinking Agent CL-1 is as follows.

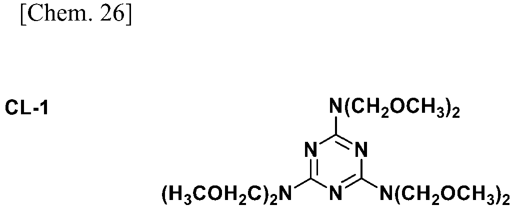

In Tables 2 and 3, Resin A'-1 is as follows.

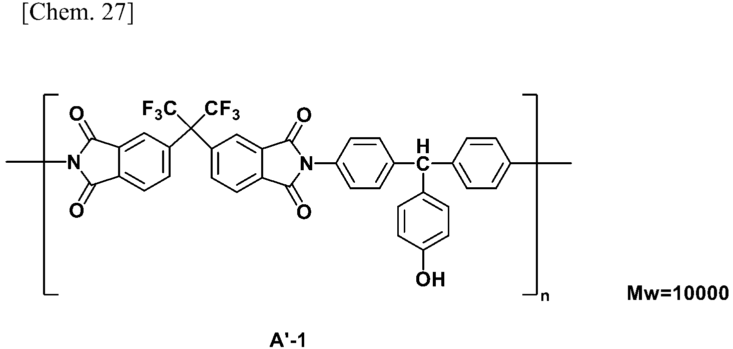

### [3] Production of Photosensitive Dry Film

Using a die coater as the film coater and a polyethylene terephthalate film (thickness, 38 µm) as the support film, the photosensitive resin compositions in Tables 1 to 3 were each applied onto the support film. In each example, the applied photosensitive resin composition was then dried by passing the coated film for 5 minutes through a circulating hot-air oven (length, 4 m) set to 100°C, thereby forming a photosensitive resin coating film on the support film and giving a photosensitive dry film. A polyethylene film (thickness, 50 µm) was laminated as a protective film onto the photosensitive resin coating film under a pressure of 1 MPa using a laminate roll, thereby producing a photosensitive dry film with protective film. The thickness of each photosensitive resin coating film was set to 100 µm. The thickness of the photosensitive resin coating film was measured with an optical interference film measurement system (F50-EXR, from Filmetrics, Inc.).

### [4] Evaluation of Resin Coating Film

### (1) Pattern Formation and Evaluation Thereof

The protective film was peeled from the above photosensitive dry film with protective film and, using the TEAM-100RF vacuum laminator (Takatori Corporation) and setting the degree of vacuum within the vacuum chamber to 80 Pa, the photosensitive resin coating film on the support film was bonded to a migration test board (an interdigitated electrode substrate in which the conductive material is copper, the conductor spacing and conductor width are each 10 µm, and the conductor thickness is 4 µm). The temperature was set to 100°C. The system was returned to normal pressure, after which the board was removed from the vacuum laminator and the support film was peeled off. Next, to increase adhesion with the board, 5 minutes of preheating was carried out at 120°C using a hot plate. The resulting photosensitive resin coating film was exposed through a mask to 365 nm wavelength light using a contact aligner so as to form a line-and-space pattern and a contact hole pattern. Subsequent to exposure, a 5-minute PEB was carried out at 140°C on a hot plate. This was followed by cooling, after which 300-second spray development with PGMEA was carried out, forming a pattern.

The photosensitive resin coating film on a substrate that was patterned by the above method was post-cured at 180°C for 2 hours in an oven while purging with nitrogen. Next, 300 µm, 150 µm and 100 µm contact hole pattern cross-sections were examined with a scanning electron microscope (SEM), and the smallest hole pattern in which the holes pass through to the bottom of the film was taken to be the resolution limit. In addition, the verticality of the 300 µm contact hole pattern was evaluated from the cross-sectional images obtained. Vertical patterns were rated as "⊚"; cases in which reverse tapering or footings are slightly noticeable were rated as "○"; cases in which reverse tapering or footings are clearly noticeable were rated as "△"; and cases in which the openings are defective were rated as "×." The results are shown in Tables 4 to 6.

### (2) Evaluation of Electrical Characteristics (Copper Migration)

Tests were carried out using boards patterned by the method in (1) as boards for evaluating copper migration. Copper migration tests were carried out under the following conditions: temperature, 121°C; humidity, 100%; applied voltage, 10 V. The time it took for shorting to occur, up to 2,000 hours as the upper limit, was determined. The results are shown in Tables 4 to 6.

### (3) Evaluation of Warping Stress

The fabricated film was laminated onto an 8-inch silicon wafer using a film laminator (TEAM-100, from Takatori Corporation), after which a 5-minute prebake at 120°C was carried out on a hot plate. The film was then exposed without an intervening mask to 365 nm wavelength light using a contact aligner, following which it was cured by 2 hours of heating at 180°C in an oven. The warping stress of the cured film was measured at 25°C with a thin-film stress measurement system (FLX-2320-S, from Toho Technology Corporation). The results are shown in Tables 4 to 6.

### (4) Evaluation of Reliability (Adhesion, Crack Resistance)

Using the TEAM-100RF vacuum laminator (Takatori Corporation) and setting the degree of vacuum within the vacuum chamber to 80 Pa, the photosensitive resin coating film on the support film of the above-described photosensitive dry film with protective film was bonded to a CCL substrate having 10 mm × 10 mm square silicon chips mounted thereon. The temperature was set to 100°C. After returning the system to normal pressure, the substrate was removed from the vacuum laminator and the support film was peeled off. Next, a 5-minute prebake at 120°C was carried out on a hot plate so as to increase adhesion to the substrate. The photosensitive resin coating film thus obtained was exposed without an intervening mask to 365 nm wavelength light using a contact aligner. After exposure, a 5-minute PEB was carried out at 140°C, followed by cooling and then 2 hours of post-curing in an oven at 180°C while purging with nitrogen. Next, using a dicing saw (DAD685, from DISCO; spindle speed, 40,000 rpm; cutting speed, 20 mm/sec) equipped with a dicing blade to cut the substrate, 20 mm × 20 mm square test pieces were obtained such as to result in a 5 mm periphery around each silicon chip. The resulting test pieces (10 in each Example) were furnished to a heat cycling test (1,000 repeated cycles, each cycle consisting of holding the test pieces at -55°C for 10 minutes and at 125°C for 10 minutes). Following the heat cycling test, the resin film was checked for peeling from the wafer and for the presence or absence of cracks. Cases in which there was no peeling whatsoever and cracks did not arise were rated as "○"; cases in which peeling arose in even one test piece were rated as "×''; cases in which cracks arose in even one test piece were rated as "×." The presence or absence of peeling and cracking was checked by top-down observation with an optical microscope and by cross-sectional scanning electron microscopy. The results are shown in Tables 4 to 6.

### (5) Evaluation of Bond Strength

The substrates for warping stress measurement fabricated in (3) above were cut to a size of 2 mm × 2 mm square using a dicing saw (DAD685, from DISCO;) equipped with a dicing blade. The 2 mm × 2 mm square chips were mounted, over an intervening resin film, at 150°C and under a load of 50 mN, onto separately prepared 15 mm × 15 mm square silicon wafers (base substrates). These were then heated for 2 hours at 180°C to cure the resin film, giving test pieces. Five test pieces were produced in each Example and furnished to the bond strength measurement tests. The bond strength of the resin film layer was evaluated by measuring the resistance when separating the semiconductor chip (2 mm × 2 mm) from the base substrate (15 mm × 15 mm square silicon wafer) using a bond tester (Dage series 4000-PXY, from Nordson Dage). Testing was carried out at a test speed of 200 µm/sec and a test height of 50 µm. The results are shown in Tables 4 to 6. Each of the values shown is the average of the measurements for five test pieces. A higher value indicates a higher bond strength.

### (6) Evaluation of Bond Strength (Following Heat Resistance Test)

The test specimens for bond strength measurement that were fabricated in (5) above were left to stand for 1,000 hours in a oven heated to 220°C, following which they were removed from the oven and furnished to bond strength measurement tests in the same way as in (5). The results are shown in Tables 4 to 6.

### (7) Evaluation of Solder Resistance (Before Moisture Absorption Test)

A water-soluble flux was applied to a substrate patterned by the method in (1) above and dipped a total of three times for 30 seconds each time in a 260°C solder bath, following which the substrate was visually examined for the presence or absence of resist abnormalities. Cases in which there were no abnormalities on the coating film were rated as "○"; cases in which swelling or peeling of the coating film was observed in even a single test specimen were rated as "×." The results are shown in Table 4 to 6.

### (8) Evaluation of Solder Resistance (After Moisture Absorption Test)

A substrate patterned by the method in (1) above was placed for 1 hour in a pressure cooker at a temperature of 121°C and 100% humidity. Next, water-soluble flux was applied to the substrate, which was then dipped a total of three times for 30 seconds each time in a 260°C solder bath, following which the substrate was visually examined for the presence or absence of resist abnormalities. Cases in which there were no abnormalities on the coating film were rated as "○"; cases in which swelling or peeling of the coating film was observed in even a single test specimen were rated as "×." The results are shown in Table 4 to 6.

**[Table 4]**

| | | Example | | | | | | |
|---|---|---|---|---|---|---|---|---|
| | | 1 | 2 | 3 | 4 | 5 | 6 | 7 |
| Pattern formation | Resolution limit (µm) | 100 | 100 | 100 | 100 | 100 | 100 | 100 |
| | Patterning | ⊚ | ⊚ | ⊚ | ⊚ | ⊚ | ⊚ | ⊚ |
| Copper migration test (1,000 hr) (shorting time, hr) | | no shorting | no shorting | no shorting | no shorting | no shorting | no shorting | no shorting |
| Warping stress/MPa | | 3.9 | 4.2 | 4.1 | 4.3 | 3.8 | 4.0 | 4.2 |
| Reliability | Adhesion | ○ | ○ | ○ | ○ | ○ | ○ | ○ |
| | Crack resistance | ○ | ○ | ○ | ○ | ○ | ○ | ○ |
| Bond strength (MPa) | Initial | 17 | 16 | 16 | 17 | 16 | 15 | 15 |
| | After heat resistance test | 17 | 16 | 16 | 17 | 16 | 15 | 15 |
| Solder resistance | Initial | ○ | ○ | ○ | ○ | ○ | ○ | ○ |
| | After moisture absorption test | ○ | ○ | ○ | ○ | ○ | ○ | ○ |

**[Table 5]**

| | | Comparative Example | | | | | | | | | |
|---|---|---|---|---|---|---|---|---|---|---|---|
| | | | 1 2 | 3 | 4 | 5 | 6 | 7 | 8 | 9 | 10 |
| Pattern formation | Resolution limit (µm) | 300 | 300 | 300 | 300 | 300 | 300 | 300 | 300 | 300 | 300 |
| | Patterning | Δ | Δ | Δ | Δ | Δ | Δ | Δ | Δ | Δ | Δ |
| Copper migration test (1,000 hr) (shorting time, hr) | | 700 | 500 | 600 | 500 | 600 | 700 | 500 | 700 | 600 | 400 |
| Warping stress/MPa | | 10.4 | 11.1 | 12.2 | 12.9 | 12.3 | 10.1 | 10.2 | 11.2 | 12.1 | 12.8 |
| Reliability | Adhesion | × | × | × | × | × | × | × | × | × | × |
| | Crack resistance | × | × | × | × | × | × | × | × | × | × |
| Bond strength (Mpa) | Initial | 11 | 11 | 12 | 12 | 12 | 11 | 12 | 12 | 12 | 12 |
| | After heat resistance test | 8 | 9 | 10 | 11 | 10 | 9 | 8 | 9 | 9 | 11 |
| Solder resistance | Initial | × | × | × | × | × | × | × | × | × | × |
| | After moisture absorption test | × | × | × | × | × | × | × | × | × | × |

**[Table 6]**

| | | Comparative Example | | | | | | | | | |
|---|---|---|---|---|---|---|---|---|---|---|---|
| | | 11 | 12 | 13 | 14 | 15 | 16 | 17 | 18 | 19 | 20 |
| Pattern formation | Resolution limit (µm) | 300 | 300 | 300 | 300 | 300 | 300 | 300 | 300 | 300 | 300 |
| | Patterning | Δ | Δ | Δ | Δ | Δ | Δ | Δ | Δ | Δ | Δ |
| Copper migration test (1,000 hr) (shorting time, hr) | | 500 | 800 | 700 | 600 | 800 | 500 | 600 | 400 | 300 | 200 |
| Warping stress/MPa | | 13.8 | 13.1 | 11.8 | 10.8 | 10.9 | 11.1 | 10.5 | 13.8 | 15.1 | 15.4 |
| Reliability | Adhesion | × | × | × | × | × | × | × | × | × | × |
| | Crack resistance | × | × | × | × | × | × | × | × | × | × |
| Bond strength (Mpa) | Initial | 12 | 11 | 12 | 11 | 11 | 12 | 11 | 12 | 13 | 13 |
| | After heat resistance test | 10 | 9 | to | 9 | 9 | 10 | 10 | 10 | 11 | 11 |
| Solder resistance | Initial | × | × | × | × | × | × | × | × | × | × |
| | After moisture absorption test | × | × | × | × | × | × | × | × | × | × |

The above results demonstrate that the photosensitive resin composition and photosensitive dry film of the invention are able to easily carry out the formation of a vertical pattern of small geometry in a thick film, and exhibit satisfactory properties as photosensitive materials. Moreover, photosensitive resin coating films obtained from these have excellent solder resistance, heat resistance, low susceptibility to substrate warpage, excellent copper migration resistance and excellent adhesion to substrates, in addition to which they have a high reliability in terms of their crack resistance and adhesion as insulating and protective films, thus enabling their use as film-forming materials for protecting various types of electrical and electronic components, including circuit boards, semiconductor devices and display devices. This invention thus makes it possible to provide photosensitive resin compositions and photosensitive dry films of higher reliability.

## Claims

1. A photosensitive resin composition comprising:
(A) an acid-crosslinkable group-containing silicone resin,
(B) an epoxy compound of formula (B1) below 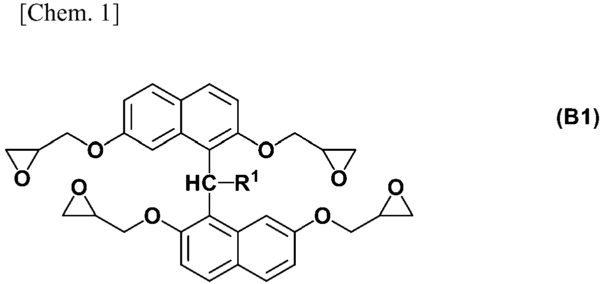 (wherein R¹ is a hydrogen atom, a saturated hydrocarbyl group of 1 to 4 carbon atoms, a phenyl group, a hydroxyphenyl group or a halogen-substituted phenyl group), and
(C) a photoacid generator.

2. The photosensitive resin composition of claim 1, wherein the silicone resin (A) is a compound of formula (A1) below 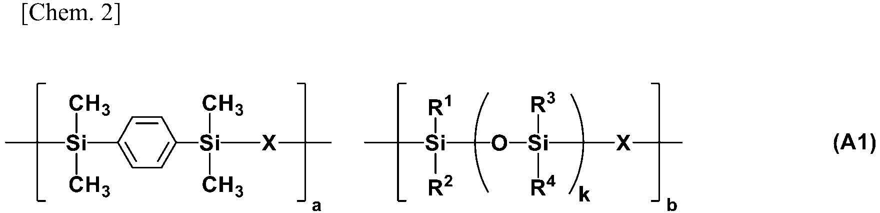 (wherein R¹ to R⁴ are each independently a hydrocarbyl group of 1 to 8 carbon atoms; k is an integer from 1 to 600; a and b are numbers which represent the compositional ratios (molar ratios) of the respective recurring units and satisfy the conditions 0 < a < 1, 0 < b < 1 and a+b = 1; and X is a divalent organic group that includes an epoxy group and/or a phenolic hydroxyl group).

3. The photosensitive resin composition of claim 2, wherein the silicone resin (A) includes recurring units of formulas (a1) to (a4) and (b1) to (b4) below 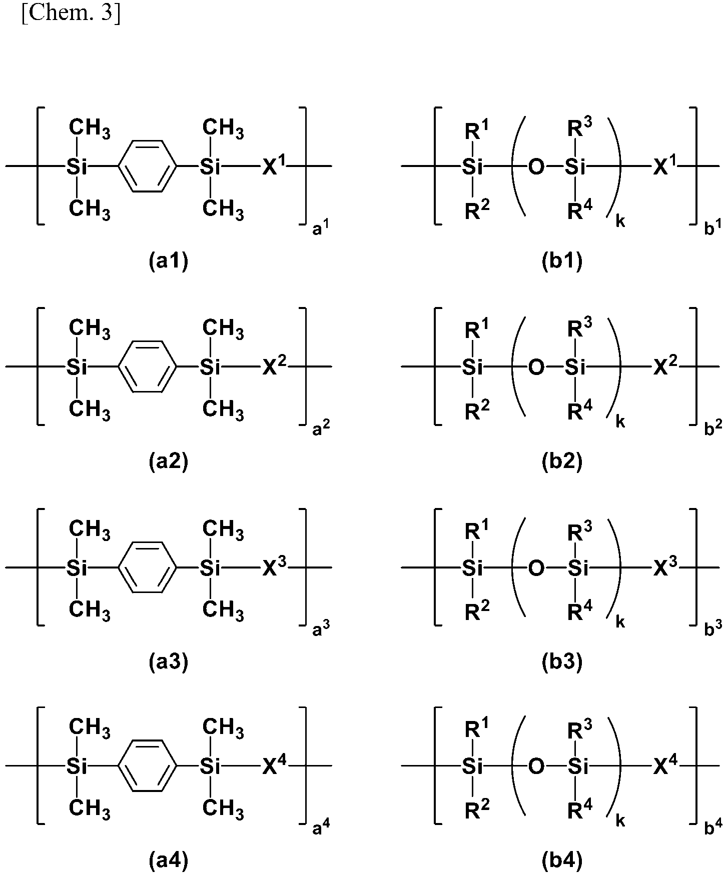
[wherein R¹ to R⁴ are each independently a hydrocarbyl group of 1 to 8 carbon atoms; k is an integer from 1 to 600; a¹ to a⁴ and b¹ to b⁴ are numbers which represent the compositional ratios (molar ratios) of the respective recurring units and satisfy the conditions 0 ≤ a¹ < 1, 0 ≤ a² < 1, 0 ≤ a³ < 1, 0 ≤ a⁴ < 1, 0 ≤ b¹ < 1, 0 ≤ b² < 1, 0 ≤ b³ < 1, 0 ≤ b⁴ < 1,0 < a¹+a²+a³ < 1, 0 < b¹+b²+b³ < 1 and a¹+a²+a³+a⁴+b^{l}+b²+b³+b⁴ = 1; X¹ is a divalent group of formula (X1) below 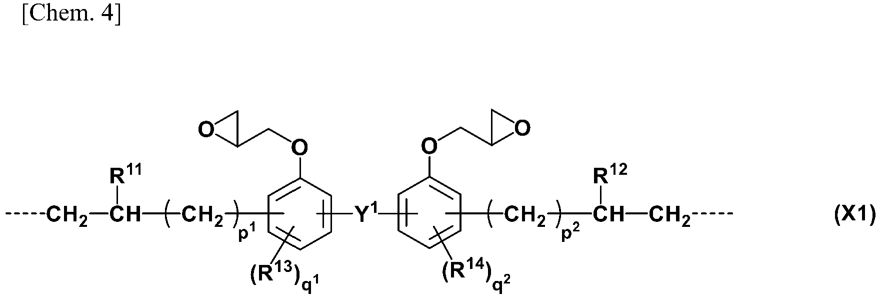
(wherein Y¹ is a single bond, a methylene group, a propane-2,2-diyl group, a 1,1,1,3,3,3-hexafluoropropane-2,2-diyl group or a fluorene-9,9-diyl group, R¹¹ and R¹² are each independently a hydrogen atom or a methyl group, R¹³ and R¹⁴ are each independently a saturated hydrocarbyl group of 1 to 4 carbon atoms or a saturated hydrocarbyloxy group of 1 to 4 carbon atoms, p¹ and p² are each independently an integer from 0 to 7, q¹ and q² are each independently an integer from 0 to 2, and the dashed lines represent bonds); X² is a divalent group of formula (X2) below 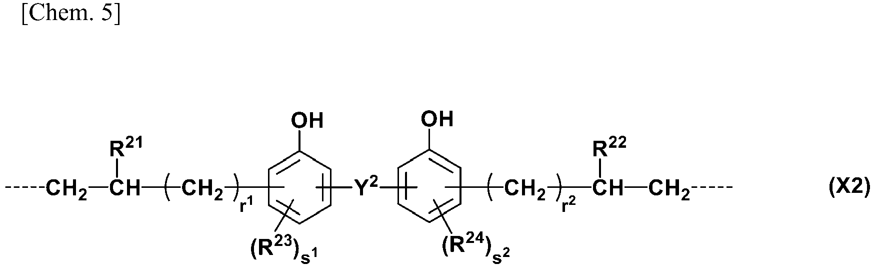
(wherein Y² is a single bond, a methylene group, a propane-2,2-diyl group, a 1,1,1,3,3,3-hexafluoropropane-2,2-diyl group or a fluorene-9,9-diyl group, R²¹ and R²² are each independently a hydrogen atom or a methyl group, R²³ and R²⁴ are each independently a saturated hydrocarbyl group of 1 to 4 carbon atoms or a saturated hydrocarbyloxy group of 1 to 4 carbon atoms, r¹ and r² are each independently an integer from 0 to 7, s¹ and s² are each independently an integer from 0 to 2, and the dashed lines represents bonds); X³ is a divalent group of formula (X3) below 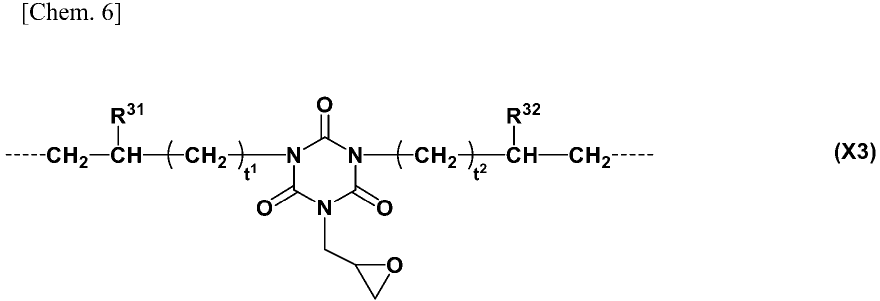
(wherein R³¹ and R³² are each independently a hydrogen atom or a methyl group, t¹ and t² are each independently an integer from 0 to 7, and the dashed lines represents bonds); and X⁴ is a divalent group of formula (X4) below 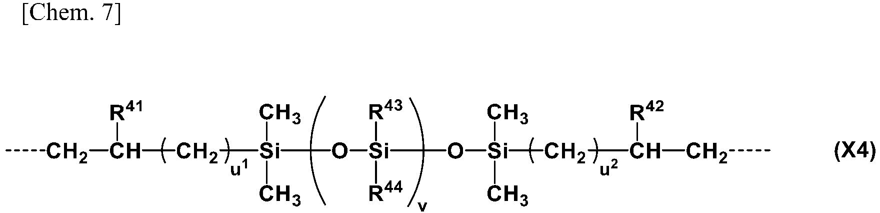
(wherein R⁴¹ and R⁴² are each independently a hydrogen atom or a methyl group, R⁴³ and R⁴⁴ are each independently a hydrocarbyl group of 1 to 8 carbon atoms, u¹ and u² are each independently an integer from 0 to 7, v is an integer from 0 to 600, and the dashed lines represent bonds)].

4. The photosensitive resin composition of claim 1, wherein the epoxy compound of component (B) is included in an amount of from 3 to 100 parts by weight per 100 parts by weight of component (A).

5. The photosensitive resin composition of claim 1, further comprising (D) a crosslinking agent.

6. The photosensitive resin composition of claim 5, wherein the crosslinking agent (D) is at least one compound selected from the group consisting of: nitrogen-containing compounds selected from melamine compounds, guanamine compounds, glycoluril compounds and urea compounds containing an average of two or more methylol groups and/or alkoxymethyl groups per molecule, amino condensation products modified by formaldehyde or formaldehyde-alcohol, phenol compounds having an average of two or more methylol or alkoxymethyl groups per molecule, and epoxy compounds having an average of two or more epoxy groups per molecule.

7. The photosensitive resin composition of claim 1, further comprising (E) a solvent.

8. A photosensitive resin coating film obtained from the photosensitive resin composition of any one of claims 1 to 7.

9. A photosensitive dry film having a support film and, on the support film, the photosensitive resin coating film of claim 8.

10. A patterning method comprising the steps of:
(i) forming a photosensitive resin coating film on a substrate by using the photosensitive resin composition of any one of claims 1 to 7,
(ii) exposing the photosensitive resin coating film to light, and
(iii) patterning the exposed photosensitive resin coating film by development with a developer.

11. A patterning method comprising the steps of:
(i') forming a photosensitive resin coating film on a substrate by using the photosensitive dry film of claim 9,
(ii) exposing the photosensitive resin coating film to light, and
(iii) patterning the exposed photosensitive resin coating film by development with a developer.

12. The patterning method of claim 10, further comprising the step of:
(iv) post-curing, at a temperature between 100°C and 250°C, the photosensitive resin coating film that has been patterned by development.

13. The photosensitive resin composition of any one of claims 1 to 7 which is a material for a coating film for protecting electrical and electronic components.

14. The photosensitive resin composition of any one of claims 1 to 7 which is a material for a substrate-bonding coating film for bonding two substrates.
